# EUROPÄISCHE PATENTSCHRIFT

(11) **EP 2 771 386 B1**
(45) Veröffentlichungstag und Bekanntmachung des Hinweises auf die Patenterteilung: **01.03.2017**
(21) Anmeldenummer: 12772721.2
(22) Anmeldetag: 01.10.2012
(51) Int. Cl.: C08G 83/00, C09K 11/00, C08G 61/12, H01L 51/00

(54) **HYPERVERZWEIGTE POLYMERE, VERFAHREN ZU DEREN HERSTELLUNG SOWIE DEREN VERWENDUNG IN ELEKTRONISCHEN VORRICHTUNGEN**
HYPERBRANCHED POLYMERS, METHODS FOR PRODUCING SAME, AND USE OF SAME IN ELECTRONIC DEVICES
POLYMÈRES HYPERRAMIFIÉS, LEURS PROCÉDÉS DE PRÉPARATION ET LEUR UTILISATION DANS DES DISPOSITIFS ÉLECTRONIQUES

(30) Priorität: 28.10.2011 DE 102011117422
(43) Veröffentlichungstag der Anmeldung: 03.09.2014
(73) Patentinhaber: Merck Patent GmbH, 64293 Darmstadt (DE)
(72) Erfinder: SCHULTE, Niels, 65779 Kelkheim (DE); REIS, Eva Maria, 64747 Breuberg (DE)
(86) Internationale Anmeldenummer: PCT/EP2012/004112
(87) Internationale Veröffentlichungsnummer: WO 2013/060411

(56) Entgegenhaltungen:
- EP-A1- 1 535 942
- US-A- 6 025 462
- KIM Y H ET AL: "HYPERBRANCHED POLYPHENYLENES", MACROMOLECULES, AMERICAN CHEMICAL SOCIETY, WASHINGTON, DC; US, Bd. 25, Nr. 21, 12. Oktober 1992 (1992-10-12), Seiten 5561-5572, XP000315427, ISSN: 0024-9297, DOI: 10.1021/MA00047A001

## Beschreibung

Die vorliegende Erfindung betrifft hyperverzweigte Polymere, Verfahren zu deren Herstellung sowie die zur Herstellung notwendigen Ausgangsverbindungen. Weiterhin betrifft die vorliegende Erfindung die Verwendung der erfindungsgemäßen hyperverzweigten Polymere in elektronischen Vorrichtungen sowie die elektronischen Vorrichtungen selbst.

Elektronische Vorrichtungen, welche organische, metallorganische und/oder polymere Halbleiter enthalten, gewinnen zunehmend an Bedeutung, wobei diese aus Kostengründen und aufgrund ihrer Leistungsfähigkeit in vielen kommerziellen Produkten eingesetzt werden. Als Beispiele seien hier Ladungstransportmaterialien auf organischer Basis (z.B. Lochtransporter auf Triarylamin-Basis) in Kopiergeräten, organischen oder polymeren Leuchtdioden (OLEDs oder PLEDs) und in Anzeige- und Displayvorrichtungen oder organische Photorezeptoren in Kopierern genannt. Organische Solarzellen (O-SC), organische FeldeffektTransistoren (O-FET), organische Dünnfilm-Transistoren (O-TFT), organische Schaltelemente (O-IC), organische optische Verstärker und organische Laserdioden (O-Laser) sind in einem fortgeschrittenen Entwicklungsstand und können in der Zukunft große Bedeutung erlangen.

Viele dieser elektronischen Vorrichtungen weisen unabhängig von dem jeweiligen Verwendungszweck folgenden allgemeinen Schichtaufbau auf, der für die jeweilige Anwendung angepasst werden kann:
(1) Substrat,
(2) Elektrode, häufig metallisch oder anorganisch, aber auch aus organischen bzw. polymeren, leitfähigen Materialien,
(3) Ladungsinjektionsschicht/en bzw. Zwischenschicht/en, beispielsweise zum Ausgleich von Unebenheiten der Elektrode ("planarisation layer"), häufig aus einem leitfähigen, dotierten Polymer,
(4) Organische Halbleiter,
(5) evtl. weitere Ladungstransport-, Ladungsinjektions- bzw. Ladungsblockierschichten,
(6) Gegenelektrode, Materialien wie unter (2) genannt,
(7) Verkapselung.

Die obige Anordnung stellt den allgemeinen Aufbau einer organischen, elektronischen Vorrichtung dar, wobei verschiedene Schichten zusammengefasst werden können, so dass im einfachsten Fall eine Anordnung aus zwei Elektroden resultiert, zwischen denen sich eine organische Schicht befindet. Die organische Schicht erfüllt in diesem Fall alle Funktionen, einschließlich der Emission von Licht im Fall von OLEDs. Ein derartiges System ist beispielsweise in der WO 90/13148 A1 auf der Basis von Poly-(p-phenylenen) beschrieben.

Ein Problem, das sich in einem derartigen "Dreischichtsystem" ergibt, ist jedoch die fehlende Steuerung der Ladungstrennung oder die fehlende Möglichkeit, die einzelnen Bestandteile in unterschiedlichen Schichten bezüglich ihrer Eigenschaften zu optimieren, wie es beispielsweise bei SMOLEDs ("small-molecule OLEDs") durch einen mehrschichtigen Aufbau einfach gelöst ist.

Eine "small molecule OLED" umfasst vielfach eine oder mehrere organische Lochinjektionsschichten, Lochtransportschichten, Emissionsschichten, Elektronentransportschichten und/oder Elektroneninjektionsschichten sowie eine Anode und eine Kathode, wobei sich das ganze System gewöhnlich auf einem Glassubstrat befindet. Der Vorteil einer solchen Mehrlagenstruktur besteht darin, dass die verschiedenen Funktionen der Ladungsinjektion, des Ladungstransports und der Emission auf die verschiedenen Schichten verteilt und somit die Eigenschaften der jeweiligen Schichten separat modifiziert werden können. Durch diese Modifikation kann die Leistungsfähigkeit der elektronischen Vorrichtungen stark verbessert werden.

Nachteilig an elektronischen Vorrichtungen, die auf den zuvor beschriebenen "small molecules", also nicht polymeren Verbindungen beruhen, ist deren Herstellung. Üblicherweise werden nicht polymere Verbindungen über Verdampfungstechniken zu elektronischen Vorrichtungen verarbeitet. Dies stellt vor allem für großflächige Vorrichtungen einen großen Kostennachteil dar, da ein mehrstufiger Vakuumprozeß in verschiedenen Kammern sehr kostenintensiv ist und sehr genau gesteuert werden muß. Hier wären kostengünstigere und etablierte Beschichtungsverfahren aus Lösung wie z.B.Tintenstrahldruck, Airbrushverfahren, Rolle-zu-Rolle-Prozesse, usw., von großem Vorteil. Die zuvor beschriebenen Vorrichtungen aus "small molecules" können jedoch im allgemeinen aufgrund der geringen Löslichkeit der nicht polymeren Verbindungen in den üblichen Lösungsmitteln nicht auf diese Art und Weise hergestellt werden. Zwar kann die Löslichkeit dieser Verbindungen durch Modifikation verbessert werden, jedoch zeigen die erhaltenen elektronischen Vorrichtungen eine im Vergleich zu den über Gasphasenabscheidung erhaltenen Vorrichtungen verringerte Leistungsfähigkeit und Lebensdauer.

In der EP 1535942 A1 wird ein Verfahren zur Herstellung eines Dendrimeren offenbart. Das Dendrimer weist dabei einen linearen und einen verzweigten Teil auf, wobei der lineare Teil eine Thienyl-Einheit und der verzweigte Teil eine gegebenenfalls substituierte trivalente Gruppe umfasst.

In der US 6,025,462 werden leitfähige Polymere mit einer sternartigen Struktur offenbart, die einen zentralen Kern aufweisen, von dem aus mehrere konjugierte, ladungstransportierende Gruppen ausgehen. Diese Gruppen werden dabei von konjugierten Polymeren oder Oligomeren, wie z.B. Polythiophenen, Polyanilinen oder Polyphenylenen, gebildet.

Die Herstellung von hyperverzweigten Polyphenylenen durch die Umsetzung von AB₂-Typ Monomeren, wie z.B. 3,5-Dibromphenylboronsäuren und 3,5 Dihalophenyl-Grignard Reagentien, wird von Y.H. Kim und O.W. Webster in Macromolecules, Vol. 25 (1992), No. 21, S. 5561ff beschrieben.

Als Aufgabe der vorliegenden Erfindung kann es somit angesehen werden, Materialien für elektronische Vorrichtungen, insbesondere OLEDs bereitzstellen, die einerseits die gute Performance der sogenannte "Small molecules" andererseits auch aber die gute Verarbeitbarkeit der Polymere aufweisen.

Überraschenderweise wurde gefunden, dass diese sowie weitere nicht explizit genannte Aufgaben, die jedoch aus den hierin einleitend diskutierten Zusammenhängen ohne Weiteres ableitbar oder erschließbar sind, durch hyperverzweigte Polymere mit den Merkmalen des Patentanspruchs 1 gelöst werden. Bevorzugte Ausführungsformen der erfindungsgemäßen hyperverzweigten Polymere werden in den auf Anspruch 1 rückbezogenen abhängigen Ansprüchen unter Schutz gestellt.

Gegenstand der vorliegenden Erfindung ist dementsprechend ein hyperverzweigtes Polymer enthaltend mindestens eine Einheit der allgemeinen Formel (I) 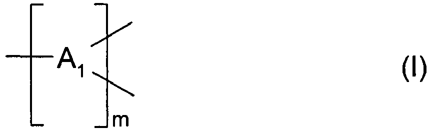 wobei
A₁ ein funktionales Strukturelement ist,
m eine ganze Zahl ≥ 3, vorzugsweise ≥ 10 und besonders bevorzugt ≥ 20. ist und
die Linien Verbindungen zu weiteren Einheiten des Polymeren darstellen und
mindestens eine Einheit der allgemeinen Formel (II) 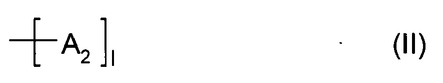 wobei
A₂ ein von A₁ verschiedenes, funktionales Strukturelement ist,
I eine ganze Zahl ≥ 1, vorzugsweise ≥ 10 und besonders bevorzugt ≥ 20, ist und
die Linie die Verbindung zu einer anderen Einheit des Polymeren darstellt, dadurch gekennzeichnet,
dass das funktionale Strukturelement A₁ und A₂ ein Strukturelement ist, das Lochinjektions- und/oder Lochtransporteigenschaften aufweist und ausgewählt ist aus Triarylamin-, Benzidin-, Tetraaryl-para-phenylendiamin-, Triarylphosphin-, Phenothiazin-, Phenoxazin-, Dihydrophenazin-, Thianthren-, Dibenzo-para-dioxin-, Phenoxathiin-, Carbazol-, Azulen-, Thiophen-, Pyrrol- und Furanderivaten und weiteren O-, S- oder N-haltigen Heterocyclen mit hoch liegendem HOMO (HOMO = höchstes besetztes Molekülorbital), oder
dass das funktionale Strukturelement A₁ und A₂ ein Strukturelement ist, das Elektroneninjektions- und/oder Elektronentransporteigenschaften aufweist und ausgewählt ist aus Pyridin-, Pyrimidin-, Pyridazin-, Pyrazin-, Oxadiazol-, Chinolin-, Chinoxalin-, Anthracen-, Benzanthracen-, Pyren-, Perylen-, Benzimidazol-, Triazin-, Triphenylen-, Keton-, Phosphinoxid- und Phenazinderivaten, aber auch Triarylboranen und weiteren O-, S- oder N-haltigen Heterocyclen mit niedrig liegendem LUMO (LUMO = niedrigstes unbesetztes Molekülorbital),
dass das funktionale Strukturelement A₁ und A₂ ein Strukturelement ist, das Licht emittiert und ausgewählt ist aus fluoreszierenden und phosphoreszierenden Emittern, oder
dass das funktionale Strukturelement A₁ und A₂ ein Strukturelement ist, das ein Hostmaterial ist und ausgewählt ist aus Oligoarylenen, und dass mindestens eine Einheit der allgemeinen Formel (I) oder mindestens eine Einheit der allgemeinen Formel (II)
ausgewählt ist aus einer löslichkeitsvermittelnden Einheit der allgemeinen Formel (III): 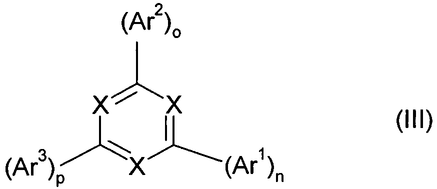 wobei
- Ar¹, Ar², Ar³: jeweils unabhängig voneinander eine Aryl- oder Heteroarylgruppe ist, welche mit einem oder mehreren beliebigen Resten R¹ substituiert sein kann,
- X: jeweils unabhängig voneinander N oder CR², vorzugsweise CH ist,
- R¹, R²: jeweils unabhängig voneinander Wasserstoff, eine geradkettige Alkyl-, Alkoxy- oder Thioalkoxygruppe mit 1 bis 40 C-Atomen oder eine verzweigte oder cyclische Alkyl-, Alkoxy- oder Thioalkoxy-gruppe mit 3 bis 40 C-Atomen ist oder eine Silylgruppe oder eine substituierte Ketogruppe mit 1 bis 40 C-Atomen, eine Alkoxy-carbonylgruppe mit 2 bis 40 C-Atomen, eine Aryloxycarbonyl-gruppe mit 7 bis 40 C-Atomen, eine Cyanogruppe (-CN), eine Carbamoylgruppe (-C(=O)NH₂), eine Haloformylgruppe (-C(=O)-X, worin X ein Halogenatom darstellt), eine Formylgruppe (-C(=O)-H), eine Isocyanogruppe, eine Isocyanatgruppe, eine Thiocyanat- gruppe oder eine Thioisocyanatgruppe, eine Hydroxygruppe, eine Nitrogruppe, eine CF₃-Gruppe, CI, Br, F, eine vernetzbare Gruppe oder ein substituiertes oder unsubstituiertes aromatisches oder heteroaromatisches Ringsystem mit 5 bis 60 Ringatomen, oder eine Aryloxy- oder Heteroaryloxygruppe mit 5 bis 60 Ringatomen, oder eine Kombination dieser Systeme ist, wobei eine oder mehrere der Gruppen R¹ und/oder R² ein mono- oder polycyclisches, aliphatisches oder aromatisches Ringsystem miteinander und/oder mit dem Ring, an dem die Gruppe R¹ gebunden ist, bilden können; und
- n, o, p: jeweils unabhängig voneinander, gleich oder verschieden 0 oder 1 sein können,
wobei gilt, dass die löslichkeitsvermittelnde Einheit der allgemeinen Formel (III) drei Bindungen zu anderen Einheiten des Polymeren aufweist, falls sie eine Einheit der allgemeinen Formel (I) darstellt, und dass die löslichkeitsvermittelnde Einheit der allgemeinen Formel (III) eine Bindung zu einer anderen Einheit des Polymeren aufweist, falls sie eine Einheit der allgemeinen Formel (II) darstellt.

In der vorliegenden Anmeldung sind unter dem Begriff Polymer sowohl polymere Verbindungen, oligomere Verbindungen, sowie Dendrimere zu verstehen. Die erfindungsgemäßen polymeren Verbindungen weisen vorzugsweise 10 bis 10000, besonders bevorzugt 15 bis 1000 und insbesondere 20 bis 500 Struktureinheiten auf. Die erfindungsgemäßen oligomeren Verbindungen weisen vorzugsweise 3 bis 9 Struktureinheiten auf.

Der Verzweigungs-Faktor der Polymere liegt dabei zwischen 0 (lineares Polymer, ohne Verzweigungsstellen) und 1 (vollständig verzweigtes Dendrimer), vorzugsweise zwischen 0,1 und 0,9 und besonders bevorzugt zwischen 0,25 und 0,75.

Abgesehen von der Bedingung, dass mindestens eine Einheit der allgemeinen Formel (I) bzw. mindestens eine Einheit der allgemeinen Formel (II) eine löslichkeitsvermittelnde Einheit der allgemeinen Formel (III) darstellen muss, unterliegt weder das funktionale Strukturelement A₁ der Einheit der allgemeinen Formel (I) noch das funktionale Strukturelement A₂ der allgemeinen Formel (II) irgendeiner besonderen Begrenzung. Es können somit alle bekannten Materialien, die in elektronischen Vorrichtungen zum Erzielen funktionaler Eigenschaften eingesetzt werden können, als Einheiten der allgemeinen Formel (I) bzw. als Einheiten der allgemeinen Formel (II) in den erfindungsgemäßen hyperverzweigten Polymeren eingesetzt werden.

Dies sind u.a. solche, wie sie in der WO 02/077060 A1 und in der WO 2005/014689 A2 offenbart und umfangreich aufgelistet sind. Diese werden via Zitat als Bestandteil der vorliegenden Erfindung betrachtet. Die funktionalen Strukturelemente A₁ sowie A₂ können beispielsweise aus den folgenden Klassen stammen:
- Gruppe 1:: Einheiten, die Lochinjektions- und/oder Lochtransporteigenschaften aufweisen;
- Gruppe 2:: Einheiten, die Elektroneninjektions- und/oder Elektronentransporteigenschaften aufweisen;
- Gruppe 3:: Einheiten, welche lichtemittierende Eigenschaften aufweisen;
- Gruppe 4:: Einheiten, die als Host-Materialien oder Co-Host-Materialien dienen können;
- Gruppe 5:: Einheiten, welche den Übergang vom so genannten Singulettzum Triplettzustand verbessern.

Strukturelemente aus der Gruppe 1, die Lochinjektions- und/oder Lochtransporteigenschaften aufweisen, sind beispielsweise Triarylamin-, Benzidin-, Tetraaryl-para-phenylendiamin-, Triarylphosphin-, Phenothiazin-, Phenoxazin-, Dihydrophenazin-, Thianthren-, Dibenzo-para-dioxin-, Phenoxathiin-, Carbazol-, Azulen-, Thiophen-, Pyrrol- und Furanderivate und weitere O-, S- oder N-haltige Heterocyclen mit hoch liegendem HOMO (HOMO = höchstes besetztes Molekülorbital).

Insbesondere zu nennen sind als Strukturelemente aus der Gruppe 1, die Lochinjektions- und/oder Lochtransporteigenschaften aufweisen, Phenylendiamin-Derivate (US 3615404), Arylamin-Derivate (US 3567450), Amino-substituierte Chalcon-Derivate (US 3526501), Styrylanthracen-Derivate (JP-A-56-46234), Polyzyklische aromatische Verbindungen (EP 1009041), Polyarylalkan-Derivate (US 3615402), Fluorenon-Derivate (JP-A-54-110837), Hydrazon-Derivate (US 3717462), Acylhydrazone, Stilben-Derivate (JP-A-61-210363), Silazan-Derivate (US 4950950), Polysilane (JP-A-2-204996), Anilin-Copolymere (JP-A-2-282263), Thiophen-Oligomere (JP Heisei 1 (1989) 211399), Polythiophene, Poly(N-vinylcarbazol) (PVK), Polypyrrole, Polyaniline und andere elektrisch leitende Makromoleküle, Porphyrin-Verbindungen (JP-A-63-2956965, US 4720432), aromatische Dimethyliden-Typ-Verbindungen, Carbazol-Verbindungen wie z.B. CDBP, CBP, mCP, aromatische tertiäre Amin- und Styrylamin-Verbindungen (US 4127412) wie z.B. Triphenylamine vom Benzidin-Typ, Triphenylamine vom Styrylamin-Typ und Triphenylamine vom Diamin-Typ. Auch Arylamin-Dendrimere können verwendet werden (JP Heisei 8 (1996) 193191), monomere Triarylamine (US 3180730), Triarylamine mit einem oder mehreren Vinylradikalen und/oder mindestens einer funktionellen Gruppe mit aktivem Wasserstoff (US 3567450 und US 3658520) oder Tetraaryldiamine (die zwei Tertiäramineinheiten sind über eine Arylgruppe verbunden). Es können auch noch mehr Triarylamino-gruppen im Molekül vorhanden sein. Auch Phthalocyanin-Derivate, Naphthalocyanin-Derivate, Butadien-Derivate und Chinolinderivate wie z.B. Dipyrazino[2,3-f:2',3'-h]quinoxalinhexacarbonitril sind geeignet.

Bevorzugt sind aromatische tertiäre Amine mit mindestens zwei Tertiäramin-Einheiten (US 2008/0102311 A1, US 4720432 und US 5061569), wie z.B. NPD (α-NPD = 4,4'-bis[N-(1-naphthyl)-N-phenylamino]biphenyl) (US 5061569), TPD 232 (= N,N'-Bis-(N,N'-diphenyl-4-aminophenyl)-N,N-diphenyl-4,4'-diamino-1,1'-biphenyl) oder MTDATA (MTDATA oder m-MTDATA= 4, 4', 4"-Tris[3-methylphenyl)phenylamino]triphenylamin) (JP-A-4-308688), TBDB (= N,N,N',N'-Tetra(4-biphenyl)diaminobiphenylen), TAPC (= 1,1-Bis(4-di-p-tolylaminophenyl)-cyclohexan), TAPPP (= 1,1-Bis(4-di-p-tolylaminophenyl)-3-phenylpropan), BDTAPVB (= 1,4-Bis[2-[4-[N,N-di(p-tolyl)amino]phenyl]vinyl]benzol), TTB (= N,N,N',N'-Tetra-*p*-tolyl-4,4'-diaminobiphenyl), TPD (= 4,4'-Bis[N-3-methylphenyl]-N-phenylamino)biphenyl), N,N,N',N'-Tetraphenyl-4,4"'-diamino-1,1',4',1",4",1"'-quaterphenyl, ebenso tertiäre Amine mit Carbazol-Einheiten wie z.B. TCTA (= 4-(9H-Carbazol-9-yl)-N,N-bis[4-(9H-carbazol-9-yl)phenyl]benzolamin). Ebenfalls bevorzugt sind Hexaaza-Triphenylen-Verbindungen gemäß US 2007/0092755 A1 sowie Phthalocyanin-Derivate (z.B. H₂Pc, CuPc (= Kupfer-Phthalocyanin), CoPc, NiPc, ZnPc, PdPc, FePc, MnPc, ClAlPc, ClGaPc, ClInPc, CISnPc, Cl₂SiPc, (HO)AIPc, (HO)GaPc, VOPc, TiOPc, MoOPc, GaPc-O-GaPc).

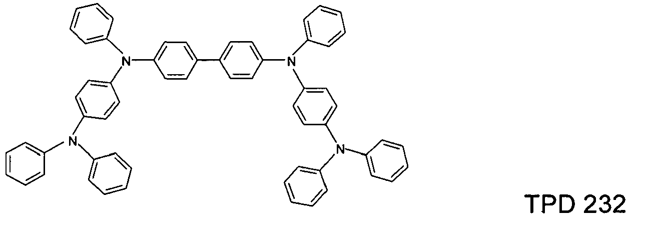

Besonders bevorzugt sind folgende Triarylamin-Verbindungen, die auch substituiert sein können: 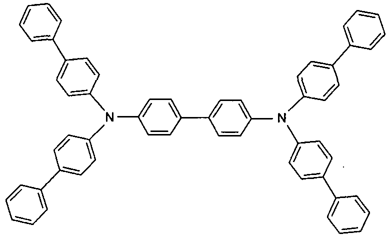 TBDB: EP 1162193 B1 und EP 650955 B1 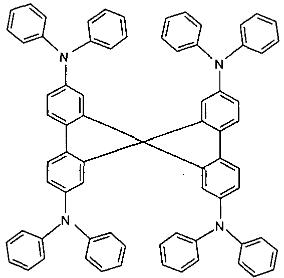 Synth.Metals 1997, 91(1-3), 209 und DE 19646119 A1 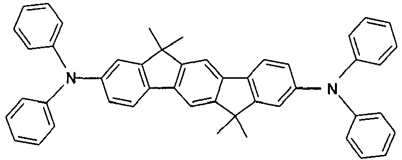 WO 2006 122630 A1 und EP 1860097 A1 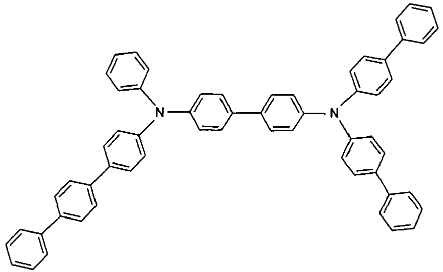 EP 1834945 A1 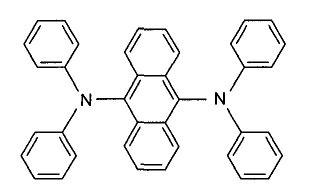 JP 08053397 A und US 6251531 B1 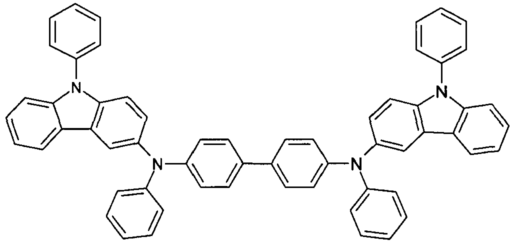 EP 1661888 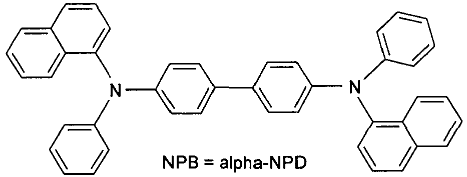 NPB = 4,4'-Bis[N-(1-naphthyl)-N-phenylamino]biphenyl 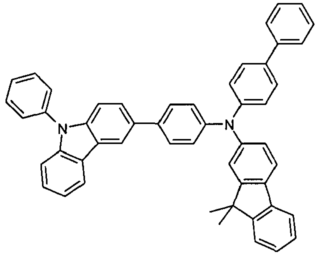 US 2005/0221124 , WO 09/041635 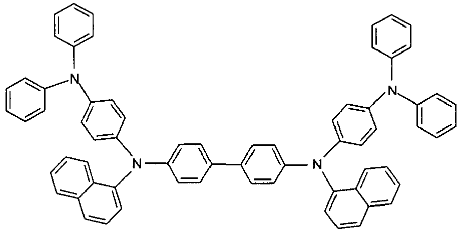 US 7399537 B2 , US 2006 0061265 A1 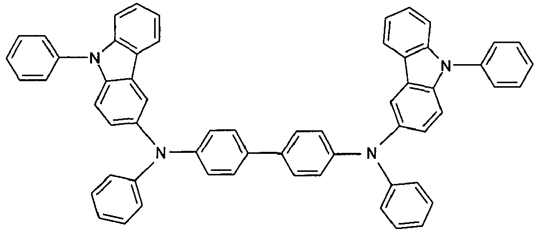 EP 1661888 B1 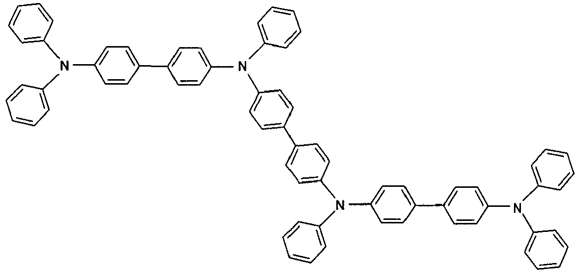 JP 08292586 A

Weitere Strukturelemente, die als Lochinjektionsmaterialien eingesetzt werden können, sind beschrieben in der EP 0891121 A1 und der EP 1029909 A1, Injektionsschichten allgemein in der US 2004/0174116 A1.

Vorzugsweise führen diese Arylamine und Heterocyclen, die im allgemeinen als Strukturelemente der Gruppe 1 eingesetzt werden, zu einem HOMO im Polymer von mehr als -5,8 eV (gegen Vakuumlevel), besonders bevorzugt von mehr als -5,5 eV.

Bevorzugte Strukturelemente aus der Gruppe 1, die Lochinjektions- und/oder Lochtransporteigenschaften aufweisen, sind Triarylamin-, Triarylphosphin- und Carbazolderivate. Besonders bevorzugt sind Triphenylamin-, Triphenylphophin- und n-Phenyl-Carbazolderivate. Unter einem Derivat einer Struktureinheit wird dabei in der vorliegenden Anmeldung die unsubstituierte oder durch einen oder mehrere Reste R¹ substituierte Struktureinheit verstanden. R¹ kann dabei die in Bezug auf die Einheit der allgemeinen Formel (III) angegebenen Bedeutungen annehmen. Die bevorzugten sowie besonders bevorzugten Strukturelemente können dabei sowohl als Einheiten der allgemeinen Formel (I) als auch als Einheiten der allgemeinen Formel (II) eingesetzt werden.

Strukturelemente aus der Gruppe 2, die Elektroneninjektions- und/oder Elektronentransporteigenschaften aufweisen, sind beispielsweise Pyridin-, Pyrimidin-, Pyridazin-, Pyrazin-, Oxadiazol-, Chinolin-, Chinoxalin-, Anthracen-, Benzanthracen-, Pyren-, Perylen-, Benzimidazol-, Triazin-, Triphenylen-, Keton-, Phosphinoxid- und Phenazinderivate, aber auch Triarylborane und weitere O-, S- oder N-haltige Heterocyclen mit niedrig liegendem LUMO (LUMO = niedrigstes unbesetztes Molekülorbital).

Besonders geeignete Strukturelemente für elektronentransportierende und elektroneninjizierende Schichten sind Metallchelate von 8-Hydroxychinolin (z.B. LiQ, AlQ₃, GaQ₃, MgQ₂, ZnQ₂, InQ₃, ZrQ₄), BAlQ, Ga-Oxinoid-Komplexe, 4-Azaphenanthren-5-ol-Be-Komplexe (US 5529853 A),

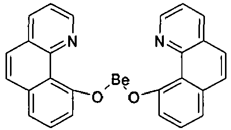

Butadienderivate (US 4356429), heterozyklische optische Aufheller (US 4539507), Benzimidazol-Derivate (US 2007/0273272 A1), wie z.B. TPBI (US 5766779),

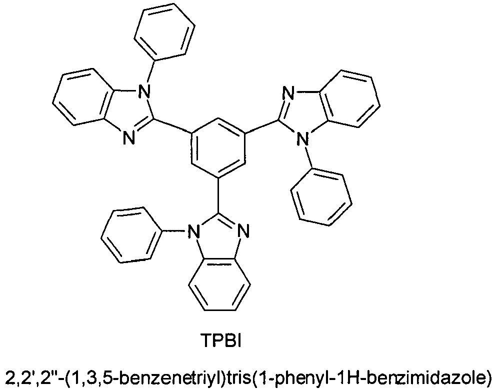

1,3,5-Triazine, z.B. Spirobifluoren-Triazin-Derivate (z.B. gemäß der DE 102008064200), Pyrene, Anthracene, Tetracene, Fluorene, Spirofluorene, Dendrimere, Tetracene (z.B. Rubren-Derivate), 1,10-Phenanthrolin-Derivate (JP 2003-115387, JP 2004-311184, JP-2001-267080, WO 2002/043449), Sila-Cyclopentadien-Derivate (EP 1480280, EP 1478032, EP 1469533), Boran-Derivate wie z.B. Triarylboranderivate mit Si, 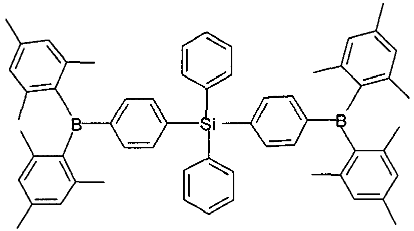 US 2007/0087219 A1

Pyridin-Derivate (JP 2004-200162), Phenanthroline, vor allem 1,10-Phenanthrolinderivate, wie z.B. BCP und Bphen, auch mehrere über Biphenyl oder andere aromatische Gruppen verbundene Phenanthroline (US-2007-0252517 A1) oder mit Anthracen verbundene Phenanthroline (US 2007-0122656 A1).

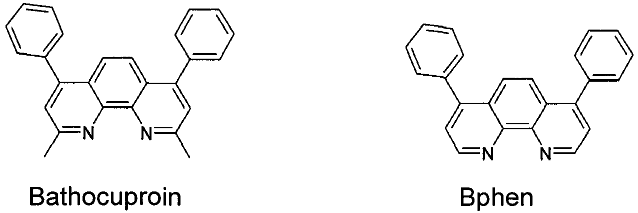

Ebenfalls geeignet sind heterozyklische organische Verbindungen wie z.B. Thiopyrandioxide, Oxazole, Triazole, Imidazole oder Oxadiazole. Beispiele für die Verwendung von Fünfringen mit N wie z.B. Oxazole, Thiazole, Oxadiazole, Thiadiazole, Triazole u.a. siehe US 2008/0102311 A1. Bevorzugte Verbindungen sind folgende:
Triazole, z.B. 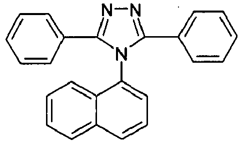 Y.A. Levin, M.S. Skorobogatova, Khimiya Geterotsiklicheskikh Soedinenii 1967 (2), 339-341 .

1,3,4-Oxadiazole, z.B. 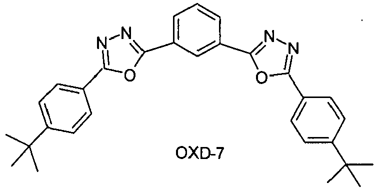 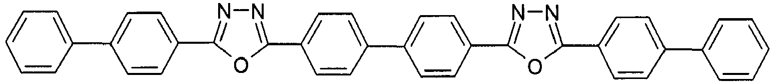 US 2007/0273272 A1 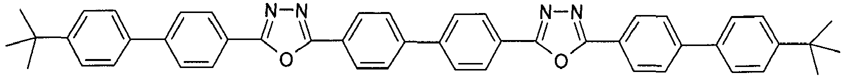 US 2007/0273272 A1 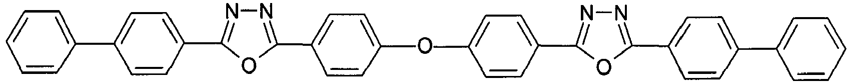 US 2007/0273272 A1

Auch organische Verbindungen wie Derivate von Fluorenon, Fluorenylidenmethan, Perylentetrakohlensäure, Anthrachinondimethan, Diphenochinon, Anthron und Anthrachinondiethylendiamin können eingesetzt werden.

Bevorzugt sind 2,9,10-substituierte Anthracene (mit 1- oder 2-Naphthyl und 4- oder 3-Biphenyl) oder Moleküle, die zwei Anthraceneinheiten enthalten (US2008/0193796 A1). Sehr vorteilhaft ist auch die Verbindung von 9,10-substituierten Anthracen-Einheiten mit Benzimidazol-Derivaten.

| | |
|---|---|
| 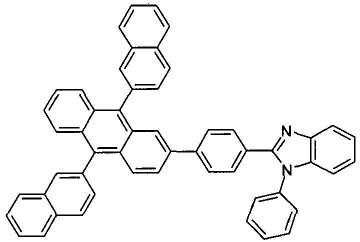 | |
| US 6878469 B2 | |
| 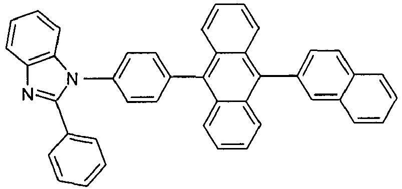 | 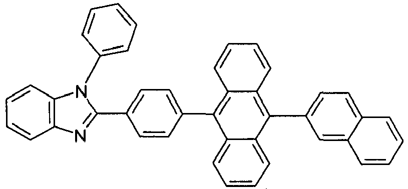 |
| US 2006 147747 A | EP 1551206 A1 |

Vorzugsweise führen die Strukturelemente aus der Gruppe 2 in einer erfindungsgemäß einzusetzenden Verbindung gemäß Formel (I) zu einem LUMO von weniger als -2,5 eV (gegen Vakuumlevel), besonders bevorzugt von weniger als -2,7 eV.

Bevorzugte Strukturelemente aus der Gruppe 2, die Elektroneninjektions- und/oder Elektronentransporteigenschaften aufweisen, sind Triazin-, Triphenylen- und Benzimidazolderivate. Unter einem Derivat einer Struktureinheit wird dabei in der vorliegenden Anmeldung die unsubstituierte oder durch einen oder mehrere Reste R¹ substituierte Struktureinheit verstanden. R¹ kann dabei die in Bezug auf die Einheit der allgemeinen Formel (III) angegebenen Bedeutungen annehmen. Die bevorzugten Strukturelemente können dabei sowohl als Einheiten der allgemeinen Formel (I) als auch als Einheiten der allgemeinen Formel (II) eingesetzt werden.

Strukturelemente aus der Gruppe 3 sind solche, welche Licht emittieren können. Hierzu gehören unter anderem Verbindungen mit Stilben-, Stilbenamin-, Styrylamin-, Coumarin-, Rubren-, Rhodamin-, Thiazol-, Thiadiazol-, Cyanin-, Thiophen-, Paraphenylen-, Perylen-, Phatolocyanin-, Porphyrin-, Keton-, Chinolin-, Imin-, Anthracen- und/oder Pyren-Strukturen. Besonders bevorzugt sind Verbindungen, die auch bei Raumtemperatur mit hoher Effizienz aus dem Triplettzustand Licht emittieren können, also Elektrophosphoreszenz statt Elektrofluoreszenz zeigen, was häufig eine Steigerung der Energieeffizienz bewirkt. Hierfür eignen sich zunächst Verbindungen, welche Schweratome mit einer Ordnungszahl von mehr als 36 enthalten. Bevorzugt sind Verbindungen, welche d- oder f-Übergangsmetalle enthalten, die die o.g. Bedingung erfüllen. Besonders bevorzugt sind hier entsprechende Strukturelemente, welche Elemente der Gruppe 8 bis 10 (Ru, Os, Rh, Ir, Pd, Pt) enthalten. Als funktionale Strukturelemente A für die Verbindungen gemäß Formel (I) kommen hier z.B. verschiedene Komplexe in Frage, wie sie z.B. in der WO 02/068435 A1, der WO 02/081488 A1, der EP 1239526 A2 und der WO 04/026886 A2 beschrieben werden.

Nachfolgend werden beispielhaft bevorzugte Strukturelemente aus der Gruppe 3 dargelegt, die als fluoreszierende Emitter dienen können. Bevorzugte Strukturelemente aus der Gruppe 3 sind ausgewählt aus der Klasse der Monostyrylamine, der Distyrylamine, der Tristyrylamine, der Tetrastyrylamine, der Styrylphosphine, der Styrylether und der Arylamine.

Unter einem Monostyrylamin wird eine Verbindung verstanden, die eine substituierte oder unsubstituierte Styrylgruppe und mindestens ein, bevorzugt aromatisches, Amin enthält. Unter einem Distyrylamin wird eine Verbindung verstanden, die zwei substituierte oder unsubstituierte Styrylgruppen und mindestens ein, bevorzugt aromatisches, Amin enthält. Unter einem Tristyrylamin wird eine Verbindung verstanden, die drei substituierte oder unsubstituierte Styrylgruppen und mindestens ein, bevorzugt aromatisches, Amin enthält. Unter einem Tetrastyrylamin wird eine Verbindung verstanden, die vier substituierte oder unsubstituierte Styrylgruppen und mindestens ein, bevorzugt aromatisches, Amin enthält. Die Styrylgruppen sind besonders bevorzugt Stilbene, die auch noch weiter substituiert sein können. Entsprechende Phosphine und Ether sind in Analogie zu den Aminen definiert. Unter einem Arylamin bzw. einem aromatischen Amin im Sinne der vorliegenden Erfindung wird eine Verbindung verstanden, die drei substituierte oder unsubstituierte aromatische oder heteroaromatische Ringsysteme direkt an den Stickstoff gebunden enthält. Bevorzugt ist mindestens eines dieser aromatischen oder heteroaromatischen Ringsysteme ein kondensiertes Ringsystem, vorzugsweise mit mindestens 14 aromatischen Ringatomen. Bevorzugte Beispiele hierfür sind aromatische Anthracenamine, aromatische Anthracendiamine, aromatische Pyrenamine, aromatische Pyrendiamine, aromatische Chrysenamine oder aromatische Chrysendiamine. Unter einem aromatischen Anthracenamin wird eine Verbindung verstanden, in der eine Diarylaminogruppe direkt an eine Anthracengruppe gebunden ist, vorzugsweise in 9-Position. Unter einem aromatischen Anthracendiamin wird eine Verbindung verstanden, in der zwei Diarylaminogruppen direkt an eine Anthracengruppe gebunden sind, vorzugsweise in 2,6- oder 9,10-Position. Aromatische Pyrenamine, Pyrendiamine, Chrysenamine und Chrysendiamine sind analog dazu definiert, wobei die Diarylaminogruppen am Pyren vorzugsweise in 1-Position bzw. in 1,6-Position gebunden sind.

Weitere bevorzugte Strukturelemente aus der Gruppe 3 sind ausgewählt aus Indenofluorenaminen bzw. -diaminen, beispielsweise gemäß der WO 06/122630, Benzoindenofluorenaminen bzw. -diaminen, beispielsweise gemäß der WO 08/006449, und Dibenzoindenofluorenaminen bzw.
- diaminen, beispielsweise gemäß der WO 07/140847.

Beispiele für Strukturelemente der Gruppe 3 aus der Klasse der Styrylamine sind substituierte oder unsubstituierte Tristilbenamine oder die Dotanden, die in der WO 06/000388, der WO 06/058737, der WO 06/000389, der WO 07/065549 und der WO 07/115610 beschrieben sind. Distyrylbenzol- und Distyrylbiphenyl-Derivate sind beschrieben in der US 5121029. Weitere Styrylamine sind in der US 2007/0122656 A1 zu finden.

Besonders bevorzugte Styrylamin-Strukturelemente der Gruppe 3 sind: 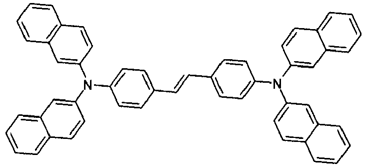 US 7250532 B2 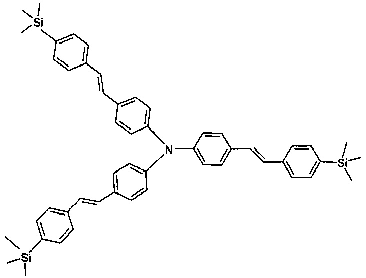 DE 10 2005 058557 A1

Besonders bevorzugte Triarylamin-Strukturelemente der Gruppe 3 sind:

| | |
|---|---|
| 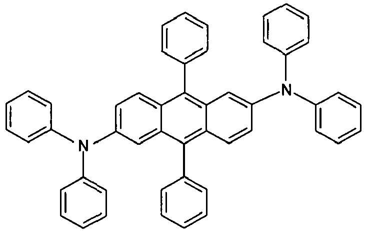 | 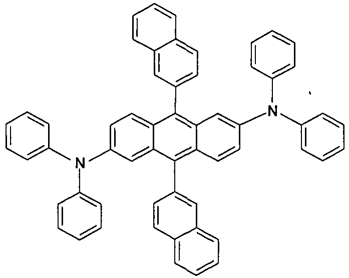 |
| CN 1583691 A | CN 1583691 A |
| 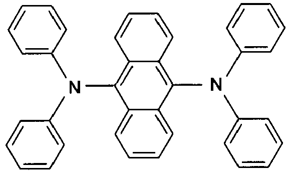 | |
| JP 08/053397 A und US 6251531 B1, Derivate in EP 1957606 A1 und US 2008/0113101 A1. | |
| 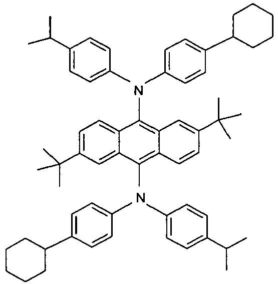 | 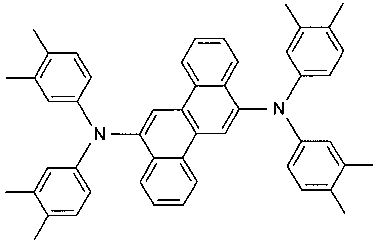 |
| EP 1957606 A1 | US 2006/210830 A |
| 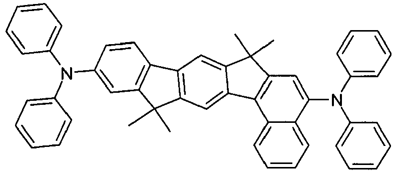 | 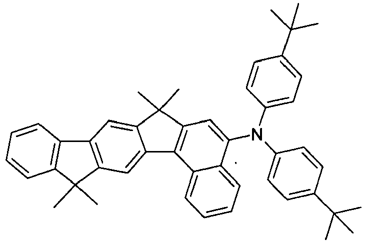 |
| WO 08/006449 | WO 08/006449 |
| 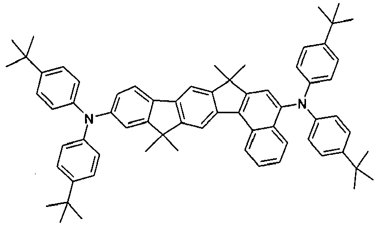 | 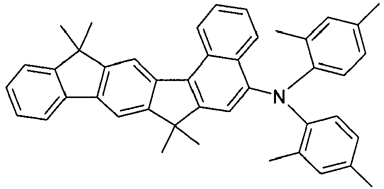 |
| WO 08/006449 | WO 08/006449 |
| 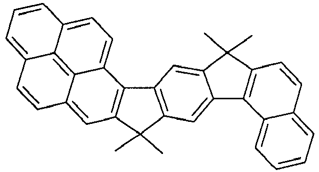 | 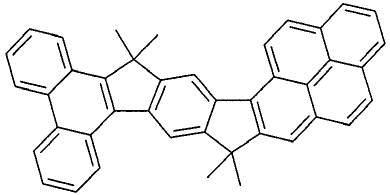 |
| DE 102008035413 | DE 102008035413 |
| 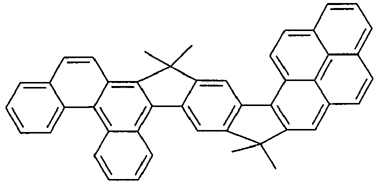 | 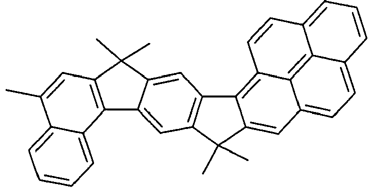 |
| DE 102008035413 | DE 102008035413 |

Weitere bevorzugte Strukturelemente der Gruppe 3 sind ausgewählt aus Derivaten von Naphthalin, Anthracen, Tetracen, Benzanthracen, Benzphenanthren (DE 10 2009 005746), Fluoren, Fluoranthen, Periflanthen, Indenoperylen, Phenanthren, Perylen (US 2007/0252517 A1), Pyren, Chrysen, Decacyclen, Coronen, Tetraphenylcyclopentadien, Pentaphenylcyclopentadien, Fluoren, Spirofluoren, Rubren, Cumarin (US 4769292, US 6020078, US 2007/0252517 A1), Pyran, Oxazol, Benzoxazol, Benzothiazol, Benzimidazol, Pyrazin, Zimtsäureestern, Diketopyrrolopyrrol, Acridon und Chinacridon (US 2007/0252517 A1).

Von den Anthracenverbindungen sind besonders bevorzugt in 9,10-Position substituierte Anthracene wie z.B. 9,10-Diphenylanthracen und 9,10-Bis(phenylethynyl)anthracen. Auch 1,4-Bis(9'-ethynylanthracenyl)-benzol ist ein bevorzugter Dotand.

Ebenfalls bevorzugt sind Derivate von Rubren, Cumarin, Rhodamin, Chinacridon wie z.B. DMQA (= N,N'-dimethylchinacridon), Dicyanomethylenpyran wie z.B. DCM (= 4-(dicyanoethylen)-6-(4-dimethylaminostyryl-2-methyl)-4H-pyran), Thiopyran, Polymethin, Pyrylium- und Thiapyryliumsalzen, Periflanthen und Indenoperylen.

Blaue Fluoreszenzemitter sind vorzugsweise Polyaromaten wie z.B. 9,10-Di(2-naphthylanthracen) und andere Anthracen-Derivate, Derivate von Tetracen, Xanthen, Perylen wie z.B. 2,5,8,11-Tetra-*t*-butyl-perylen, Phenylen, z.B. 4,4'-(Bis(9-ethyl-3-carbazovinylen)-1,1'-biphenyl, Fluoren, Fluoranthen, Arylpyrene (US 2006/0222886 A1), Arylenvinylene (US 5121029, US 5130603), Bis(azinyl)imin-Bor-Verbindungen (US 2007/0092753 A1), Bis(azinyl)methenverbindungen und Carbostyryl-Verbindungen.

Weitere bevorzugte blaue Fluoreszenzemitter sind in C.H.Chen et al.: "Recent developments in organic electroluminescent materials" Macromol. Symp. 125, (1997) 1-48 und "Recent progress of molecular organic electroluminescent materials and devices" Mat. Sci. and Eng. R, 39 (2002), 143-222 beschrieben.

Weitere bevorzugte blau fluoreszierende Emitter sind die in der DE 102008035413 offenbarten Kohlenwasserstoffe.

Nachfolgend werden beispielhaft bevorzugte Strukturelemente aus der Gruppe 3 dargelegt, die als phosphoreszierende Emitter dienen können.

Beispiele für phosphoreszierende Emitter können der WO 00/70655, der WO 01/41512, der WO 02/02714, der WO 02/15645, der EP 1191613, der EP 1191612, der EP 1191614 und der WO 05/033244 entnommen werden. Generell eignen sich alle phosphoreszierenden Komplexe, wie sie gemäß dem Stand der Technik für phosphoreszierende OLEDs verwendet werden und wie sie dem Fachmann auf dem Gebiet der organischen Elektrolumineszenz bekannt sind, und der Fachmann kann ohne erfinderisches Zutun weitere phosphoreszierende Komplexe verwenden.

Phosphoreszierende Metallkomplexe enthalten vorzugsweise Ir, Ru, Pd, Pt, Os oder Re.

Bevorzugte Liganden sind 2-Phenylpyridin-Derivate, 7,8-Benzochinolin-Derivate, 2-(2-Thienyl)pyridin-Derivate, 2-(1-Naphthyl)pyridin-Derivate, 1-Phenylisochinolin-Derivate, 3-Phenylisochinolin-Derivate oder 2-Phenylchinolin-Derivate. Alle diese Verbindungen können substituiert sein, z.B. für Blau mit Fluor-, Cyano- und/oder Trifluormethylsubstituenten. Auxiliäre Liganden sind vorzugsweise Acetylacetonat oder Picolinsäure.

Insbesondere sind Komplexe von Pt oder Pd mit tetradentaten Liganden, 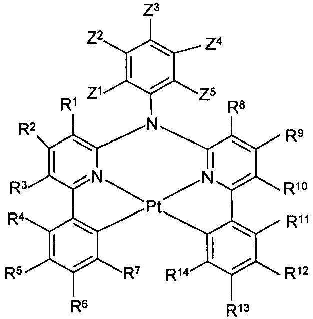 (US 2007/0087219 A1, wobei zur Erläuterung der Substituenten und Indices in obiger Formel auf diese Druckschrift zu Offenbarungszwecken verwiesen wird), Pt-Porphyrinkomplexe mit vergrößertem Ringsystem (US 2009/0061681 A1) und Ir-Komplexe geeignet, z.B. 2,3,7,8,12,13,17,18-Octaethyl-21H, 23H-porphyrin-Pt(II), Tetraphenyl-Pt(II)-tetrabenzoporphyrin (US 2009/0061681 A1), *cis*-Bis(2-phenylpyridinato-N,C^{2'})Pt(II), *cis*-Bis(2-(2'-thienyl)pyridinato-N,C^{3'})Pt(II), cis-Bis-(2-(2'-thienyl)chinolinato-N,C^{5'})Pt(II), (2-(4,6-Difluorophenyl)pyrid inato-N,C^{2'})Pt(ll)(acetylacetonat), oder Tris(2-phenylpyridinato-N,C^{2'})Ir(III) (= Ir(ppy)₃, grün), Bis(2-phenylpyridinato-N,C²)Ir(III)(acetylacetonat) (= Ir(ppy)₂acetylacetonat, grün, US 2001/0053462 A1, Baldo, Thompson et al. Nature 403, (2000), 750-753), Bis(1-phenylisochinolinato-N,C^{2'})(2-phenylpyridinato-N,C^{2'})Iridium(III), Bis(2-phenylpyridinato-N,C^{2'})(1-phenylisochinolinato-N,C^{2'})Iridium(III), Bis(2-(2'-benzothienyl)pyridinato-N,C^{3'})Iridium(III)(acetylacetonat), Bis(2-(4',6'-difluorophenyl)pyridinato-N,C^{2'})Iridium(III)(piccolinat) (Flrpic, blau), Bis(2-(4',6'-difluorophenyl)pyridinato-N,C^{2'})Ir(III)(tetrakis(1-pyrazolyl)borat), Tris(2-(biphenyl-3-yl)-4-tertbutylpyridin)iridium(III), (ppz)₂Ir(5phdpym) (US 2009/0061681 A1), (45ooppz)₂Ir(5phdpym) (US 2009/0061681 A1), Derivate von 2-Phenylpyridin-lr-Komplexen, wie z.B. PQIr (= Iridium(III)-bis(2-phenyl-quinolyl-N,C^{2'})acetylacetonat), Tris(2-phenylisochinolinato-N,C)Ir(III) (rot), Bis(2-(2'-benzo[4,5-a]thienyl)pyridinato-N,C³)Ir(acetylacetonat) ([Btₚ2Ir(acac)], rot, Adachi et al. Appl. Phys. Lett. 78 (2001), 1622-1624).

Ebenfalls geeignet sind Komplexe von trivalenten Lanthaniden wie z.B. Tb³⁺ und Eu³⁺ (J.Kido et al. Appl. Phys. Lett. 65 (1994), 2124, Kido et al. Chem. Lett. 657, 1990, US 2007/0252517 A1) oder phosphoreszente Komplexe von Pt(II), Ir(I), Rh(l) mit Maleonitrildithiolat (Johnson et al., JACS 105, 1983, 1795), Re(I)-Tricarbonyl-dümin-Komplexe (Wrighton, JACS 96, 1974, 998 u.a.), Os(II)-Komplexe mit Cyanoliganden und Bipyridyl- oder Phenanthrolin-Liganden (Ma et al., Synth. Metals 94, 1998, 245).

Weitere phosphoreszierende Emitter mit tridentaten Liganden werden beschrieben in der US 6824895 und der US 10/729238. Rot emittierende phosphoreszente Komplexe findet man in der US 6835469 und der US 6830828.

Besonders bevorzugte Strukturelemente, die als phosphoreszierende Dotanden Verwendung finden, sind: 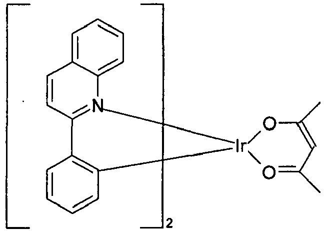 US 2001/0053462 A1 und Inorg. Chem. 2001, 40(7), 1704-1711, JACS 2001, 123(18), 4304-4312.

Derivate sind beschrieben in der US 7378162 B2, der US 6835469 B2 und der JP 2003/253145 A.

| | |
|---|---|
| 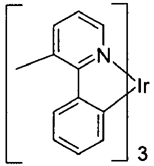 | 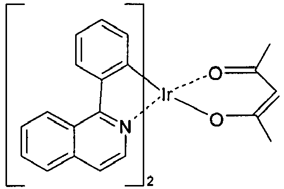 |
| US 7238437 B2 | US 2009/008607 A1 |
| 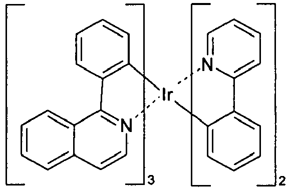 | 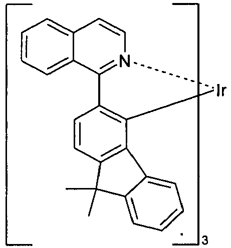 |
| US 2009/008607 A1 | EP 1348711 |

Bevorzugte Strukturelemente aus der Gruppe 3 , welche Licht emittieren können, sind Einheiten der Formeln (V-la), (V-Ib), (V-Ic) und (V-Id) 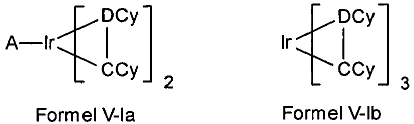 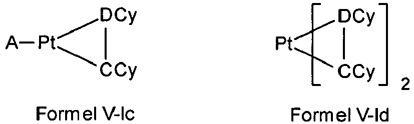 wobei für die verwendeten Symbole gilt:
- DCy: ist gleich oder verschieden bei jedem Auftreten eine cyclische Gruppe, die mindestens ein Donoratom, vorzugsweise Stickstoff, Kohlenstoff in Form eines Carbens oder Phosphor, enthält, über welches die cyclische Gruppe an das Metall gebunden ist, und die wiederum einen oder mehrere Substituenten R¹⁰ tragen kann; die Gruppen DCy und CCy sind über eine kovalente Bindung miteinander verbunden;
- CCy: ist gleich oder verschieden bei jedem Auftreten eine cyclische Gruppe, die ein Kohlenstoffatom enthält, über welches die cyclische Gruppe an das Metall gebunden ist und die wiederum einen oder mehrere Substituenten R¹⁰ tragen kann;
- A: ist gleich oder verschieden bei jedem Auftreten ein mono-anionischer, zweizähnig chelatisierender Ligand, vorzugsweise ein Diketonatligand;
- R¹⁰: ist bei jedem Auftreten gleich oder verschieden H, D, F, CI, Br, I, CHO, C(=O)Ar³, P(=O)(Ar³)₂, S(=O)Ar³, S(=O)₂Ar³, CR¹¹=CR¹¹Ar³, CN, NO₂ Si(R¹¹)₃, B(OR¹¹)₂, B(R¹¹)₂, B(N(R¹¹)₂)₂, OSO₂R¹¹, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R¹¹ substituiert sein kann, wobei eine oder mehrere nicht benachbarte CH₂-Gruppen durch R¹¹C=CR¹¹, C=C, Si(R¹¹)₂, Ge(R¹¹)₂, Sn(R¹¹)₂, C=O, C=S, C=Se, C=NR¹¹, P(=O)(R¹¹), SO, SO₂, NR¹¹, O, S oder CONR¹¹ ersetzt sein können und wobei ein oder mehrere H-Atome durch F, CI, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R¹¹ substituiert sein kann, oder eine Aryloxy- oder Heteroaryloxygruppe mit 5 bis 60 aromatischen Ringatomen, die durch einen oder mehrere Reste R¹¹ substituiert sein kann, oder eine Kombination dieser Systeme; dabei können zwei oder mehrere benachbarte Substituenten R¹⁰ auch miteinander ein mono- oder polycyclisches, aliphatisches oder aromatisches Ringsystem bilden;
- Ar³: ist bei jedem Auftreten gleich oder verschieden ein aromatisches oder heteroaromatisches Ringsystem mit 5 bis 40 aromatischen Ringatomen, das mit einem oder mehreren Resten R¹¹ substituiert sein kann;
- R¹¹: ist bei jedem Auftreten gleich oder verschieden H, D, CN oder ein aliphatischer, aromatischer und/oder heteroaromatischer Kohlen-wasserstoffrest mit 1 bis 20 C-Atomen, in dem auch H-Atome durch F ersetzt sein können; dabei können zwei oder mehrere benachbarte Substituenten R¹¹ auch miteinander ein mono- oder polycyclisches, aliphatisches oder aromatisches Ringsystem bilden,
wobei mindestens einer der genannten Reste DCy, CCy und/oder A mindestens eine Gruppe der Formel (L-I) und/oder (L-II) umfasst.

Dabei kann durch Bildung von Ringsystemen zwischen mehreren Resten R¹⁰ auch eine Brücke zwischen den Gruppen DCy und CCy vorliegen. Weiterhin kann durch Bildung von Ringsystemen zwischen mehreren Resten R¹⁰ auch eine Brücke zwischen zwei oder drei Liganden CCy-DCy bzw. zwischen ein oder zwei Liganden CCy-DCy und dem Liganden A vorliegen, so dass es sich um ein polydentates bzw. polypodales Ligandensystem handelt.

Die bevorzugten Strukturelemente aus der Gruppe 3 können dabei sowohl als Einheiten der allgemeinen Formel (I) als auch als Einheiten der allgemeinen Formel (II) eingesetzt werden, besonders bevorzugt werden sie jedoch als Einheiten der allgemeinen Formel (II) eingesetzt.

Strukturelemente aus der Gruppe 4, die als Hostmaterialien, insbesondere zusammen mit emittierenden Verbindungen eingesetzt werden, umfassen Materialien verschiedener Stoffklassen.

Bevorzugte Strukturelemente aus der Gruppe 4, die insbesondere zusammen mit fluoreszierenden Dotanden eingesetzt werden, sind ausgewählt aus den Klassen der Oligoarylene (z.B. 2,2',7,7'-Tetraphenylspirobifluoren gemäß EP 676461 oder Dinaphthylanthracen), insbesondere der Oligoarylene enthaltend kondensierte aromatische Gruppen wie z.B. Anthracen, Benzanthracen, Benzphenanthren (DE 10 2009 005746, WO 09/069566), Phenanthren, Tetracen, Coronen, Chrysen, Fluoren, Spirofluoren, Perylen, Phthaloperylen, Naphthaloperylen, Decacyclen, Rubren, der Oligoarylenvinylene (z.B. DPVBi = 4,4'-Bis(2,2-diphenylethenyl)-1,1'-biphenyl) oder Spiro-DPVBi gemäß EP 676461), der polypodalen Metallkomplexe (z.B. gemäß WO 04/081017), insbesondere Metallkomplexe von 8-Hydroxychinolin, z.B. AIQ₃ (= Aluminium(III)tris(8-hydroxychinolin)) oder Bis(2-methyl-8-chinolinolato)-4-(phenylphenolinolato)aluminium, auch mit Imidazol-Chelat (US 2007/0092753 A1) sowie der Chinolin-Metallkomplexe, Aminochinolin-Metallkomplexe, Benzochinolin-Metallkomplexe, der lochleitenden Verbindungen (z.B. gemäß WO 04/058911), der elektronenleitenden Verbindungen, insbesondere Ketone, Phosphinoxide, Sulfoxide, etc. (z.B. gemäß der WO 05/084081 und der WO 05/084082), der Atropisomere (z.B. gemäß der WO 06/048268), der Boronsäurederivate (z.B. gemäß der WO 06/117052) oder der Benzanthracene (z.B. gemäß der WO 08/145239).

Besonders bevorzugte Strukturelemente der Gruppe 4 sind ausgewählt aus den Klassen der Oligoarylene, enthaltend Anthracen, Benzanthracen und/oder Pyren oder Atropisomere dieser Verbindungen. Unter einem Oligoarylen im Sinne der vorliegenden Erfindung soll eine Verbindung verstanden werden, in der mindestens drei Aryl- bzw. Arylengruppen aneinander gebunden sind.

Bevorzugte Hostmaterialien sind insbesondere ausgewählt aus Verbindungen der Formel (H-1),

Ar³-(Ar⁴)ₚ-Ar⁵ (H-1)

wobei Ar³, Ar⁴, Ar⁵ bei jedem Auftreten gleich oder verschieden eine Aryl- oder Heteroarylgruppe mit 5 bis 30 aromatischen Ringatomen ist, die mit einem oder mehreren Resten R¹ substituiert sein kann, und R¹ dieselbe Bedeutung hat, wie oben beschrieben, und p eine ganze Zahl im Bereich von 1 bis 5 darstellt; dabei gilt, dass die Summe der π-Elektronen in Ar³, Ar⁴ und Ar⁵ mindestens 30 beträgt, wenn p = 1 ist, und mindestens 36 beträgt, wenn p = 2 ist, und mindestens 42 beträgt, wenn p = 3 ist.

Besonders bevorzugt steht in den Verbindungen der Formel (H-1) die Gruppe Ar⁴ für Anthracen, welches durch einen oder mehrere Reste R¹ substituiert sein kann, und die Gruppen Ar³ und Ar⁵ sind in 9- und 10-Position gebunden. Ganz besonders bevorzugt ist mindestens eine der Gruppen Ar³ und/oder Ar⁵ eine kondensierte Arylgruppe, ausgewählt aus 1-oder 2-Naphthyl, 2-, 3- oder 9-Phenanthrenyl oder 2-, 3-, 4-, 5-, 6- oder 7-Benzanthracenyl, welche jeweils durch einen oder mehrere Reste R¹ substituiert sein kann. Anthracen-basierte Verbindungen sind beschrieben in der US 2007/0092753 A1 und der US 2007/0252517 A1, z.B. 2-(4-Methylphenyl)-9,10-di-(2-naphthyl)anthracen, 9-(2-Naphthyl)-10-(1,1'-biphenyl)anthracen und 9,10-Bis[4-(2,2-diphenylethenyl)phenyl]anthracen, 9,10-Diphenylanthracen, 9,10-Bis(phenylethynyl)anthracen und 1,4-Bis(9'-ethynylanthracenyl)benzol. Bevorzugt sind auch Verbindungen mit zwei Anthraceneinheiten (US 2008/0193796 A1), z.B. 10,10'-Bis[1,1',4', 1"]terphenyl-2-yl-9,9'-bisanthracenyl.

Weitere bevorzugte Verbindungen sind Derivate von Arylamin, Styrylamin, Fluorescein, Diphenylbutadien, Tetraphenylbutadien, Cyclopentadiene, Tetraphenylcyclopentadien, Pentaphenylcyclopentadien, Cumarin, Oxadiazol, Bisbenzoxazolin, Oxazol, Pyridin, Pyrazin, Imin, Benzothiazol, Benzoxazol, Benzimidazol (US 2007/0092753 A1), z.B. 2,2',2"-(1,3,5-Phenylen)tris[1-phenyl-1 H-benzimidazol], Aldazin, Stilben, Styrylarylenderivate, z.B. 9,10-Bis[4-(2,2-diphenylethenyl)phenyl]anthracen und Distyrylarylen-Derivate (US 5121029), Diphenylethylen, Vinylanthracen, Diaminocarbazol, Pyran, Thiopyran, Diketopyrrolopyrrol, Polymethin, Zimtsäureestern und Fluoreszenzfarbstoffen.

Besonders bevorzugt sind Derivate von Arylamin und Styrylamin, z.B. TNB (= 4,4'-Bis[N-(1-naphthyl)-N-(2-naphthyl)amino]biphenyl). Metall-Oxinoid-Komplexe wie LiQ oder AlQ₃ können als Co-Hosts verwendet werden.

Bevorzugte Verbindung mit Oligoarylen als Matrix:

| | |
|---|---|
| 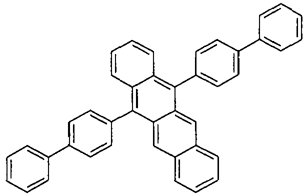 | 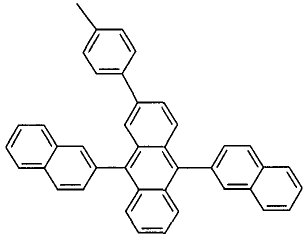 |
| US 2003/0027016 A1 | US 7326371 B2 |
| 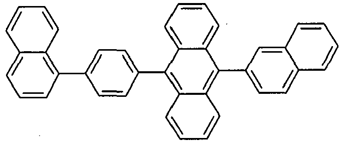 | 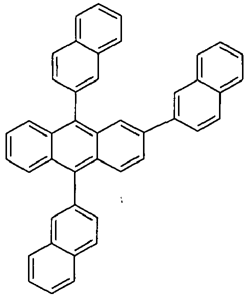 |
| US 2006/043858 A | US 7326371 B2 |
| 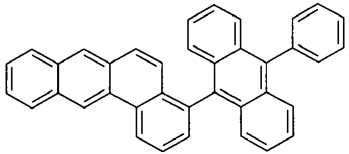 | 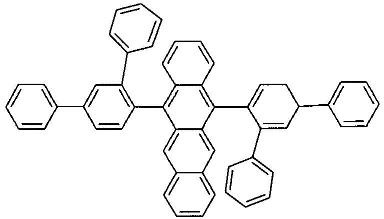 |
| WO 08/145239 | US 2003/0027016 A1 |
| 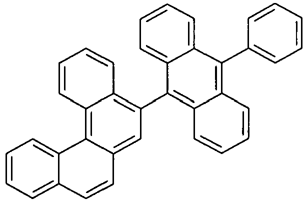 | |
| DE 102009005746 | |

Weiterhin umfassen Strukturelemente der Gruppe 4 Materialien, die zusammen mit phosphoreszierenden Emittern eingesetzt werden. Zu diesen Strukturelementen gehören CBP (N,N-Biscarbazolylbiphenyl), Carbazolderivate (z.B. gemäß WO 05/039246, US 2005/0069729, JP 2004/288381, EP 1205527 oder WO 08/086851), Azacarbazole (z.B. gemäß EP 1617710, EP 1617711, EP 1731584, JP 2005/347160), Ketone (z.B. gemäß WO 04/093207 oder gemäß der DE 102008033943), Phosphinoxide, Sulfoxide und Sulfone (z.B. gemäß WO 05/003253), Oligophenylene, aromatische Amine (z.B. gemäß US 2005/0069729), bipolare Matrixmaterialien (z.B. gemäß WO 07/137725), Silane (z.B. gemäß WO 05/111172), 9,9-Diarylfluorenderivate (z.B. gemäß der DE 102008017591), Azaborole oder Boronester (z.B. gemäß WO 06/117052), Triazin-Derivate (z.B. gemäß der DE 102008036982), Indolocarbazolderivate (z.B. gemäß WO 07/063754 oder WO 08/056746), Indenocarbazolderivate (z.B. gemäß der DE 102009023155 und der DE 102009031021), Diazaphospholderivate (z.B. gemäß der DE 102009022858), Triazol-Derivate, Oxazole und Oxazol-Derivate, Imidazol-Derivate, Polyarylalkan-Derivate, Pyrazolin-Derivate, Pyrazolon-Derivate, Distyrylpyrazin-Derivate, Thiopyrandioxid-Derivate, Phenylendiamin-Derivate, tertiäre aromatische Amine, Styrylamine, Amino-substituierte Chalcon-Derivate, Indole, Hydrazon-Derivate, Stilben-Derivate, Silazan-Derivate, aromatische Dimethyliden-Verbindungen, Carbodiimid-Derivate, Metallkomplexe von 8-Hydroxychinolin-Derivaten wie z.B. AIQ₃, die 8-Hydroxychinolin-Komplexe können auch Triarylaminophenol-Liganden enthalten (US 2007/0134514 A1), Metallkomplex-Polysilan-Verbindungen sowie Thiophen-, Benzothiophen- und Dibenzothiophen-Derivate.

Beispiele für bevorzugte Carbazol-Strukturelemente sind mCP (= 1,3-N,N-dicarbazol-benzol (= 9,9'-(1,3-Phenylen)bis-9H-carbazol)), CDBP (= 9,9'-(2,2'-Dimethyl[1,1'-biphenyl]-4,4'-diyl)bis-9H-carbazol), 1,3-Bis(N,N'-dicarbazol)benzol (= 1,3-Bis(carbazol-9-yl)benzol), PVK (Polyvinylcarbazol), 3,5-Di(9H-carbazol-9-yl)biphenyl sowie die unten abgebildeten Verbindungen. 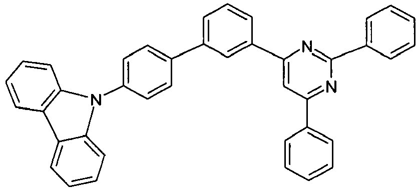 mCP 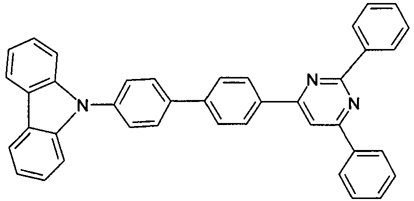 US 2005/0249976 A1 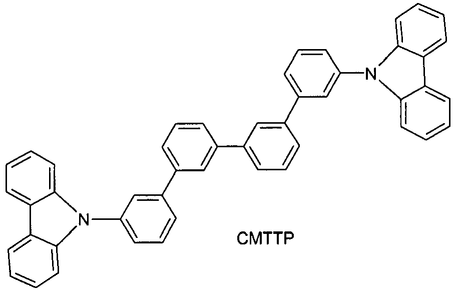 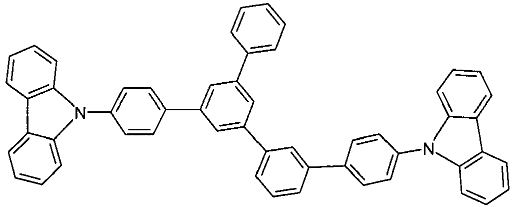 US 2007/0128467 A1 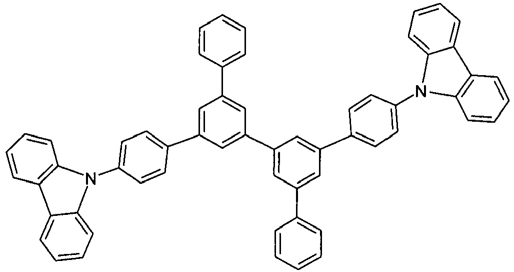 US 2007/0128467 A1

Bevorzugte Si-Tetraaryle sind z.B. (US 2004/0209115, US 2004/0209116) 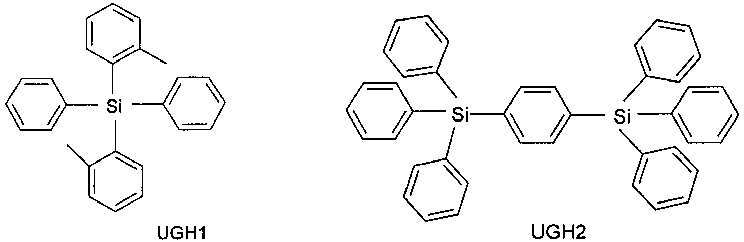 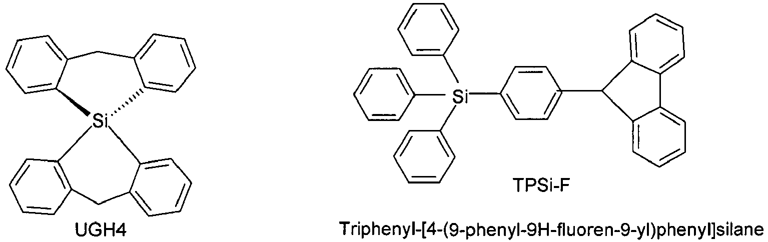 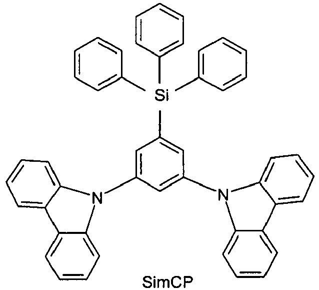 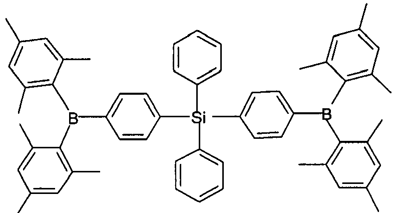 US 2007/0087219 A1 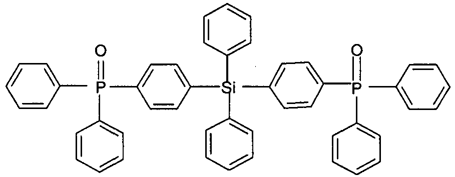 US 2007/0087219 A1 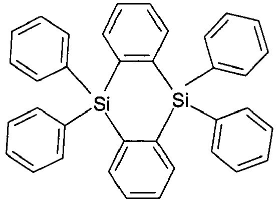 H. Gilman, E.A. Zuech, Chemistry & Industry (London, United Kingdom), 1960, 120 .

Besonders bevorzugte Strukturelemente gemäß Gruppe 4 zur Herstellung der Matrix für phosphoreszierende Dotanden sind:

| | |
|---|---|
| 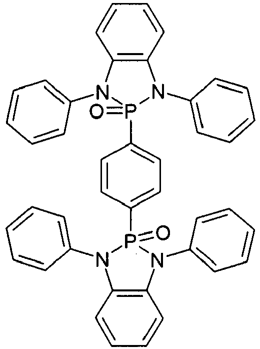 | 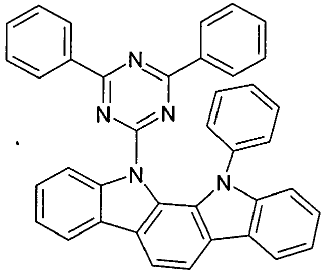 |
| DE 102009022858 | WO 07/063754 und WO 08/056746 |
| 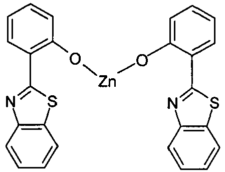 | 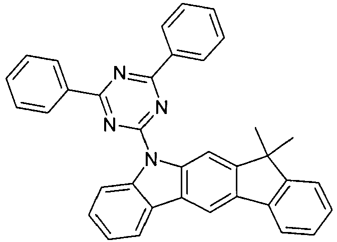 |
| EP 652273 B1 | DE 102009023155 |

Im Hinblick auf die erfindungsgemäß einsetzbaren funktionalen Verbindungen, die als Hostmaterial dienen können, sind insbesondere Stoffe bevorzugt, deren funktionales Strukturelement A mindestens ein Stickstoffatom aufweist. Hierzu gehören vorzugsweise aromatische Amine, Triazin- und Carbazol-Derivate. So zeigen insbesondere Carbazol-Derivate eine überraschend hohe Effizienz. Triazin-Derivate führen unerwartet zu hohen Lebensdauern der elektronischen Vorrichtungen mit den genannten Verbindungen.

Die bevorzugten sowie besonders bevorzugten Strukturelemente aus der Gruppe 4, die als Hostmaterialien eingesetzt werden, können dabei unsubstituiert oder durch einen oder mehrere Reste R¹ substituiert sein. R¹ kann dabei die in Bezug auf die Einheit der allgemeinen Formel (III) angegebenen Bedeutungen annehmen.

Die bevorzugten sowie besonders bevorzugten Strukturelemente aus der Gruppe 4 können dabei sowohl als Einheiten der allgemeinen Formel (I) als auch als Einheiten der allgemeinen Formel (II) eingesetzt werden, besonders bevorzugt werden sie jedoch als Einheiten der allgemeinen Formel (II) eingesetzt.

Strukturelemente der Gruppe 5 sind solche, welche den Übergang vom Singulett- zum Triplettzustand verbessern und welche, unterstützend zu den funktionalen Strukturelementen der Gruppe 3 eingesetzt, die Phosphoreszenzeigenschaften dieser Strukturelemente verbessern. Hierfür kommen insbesondere Carbazol- und überbrückte Carbazoldimereinheiten in Frage, wie sie z.B. in der WO 04/070772 A2 und der WO 04/113468 A1 beschrieben werden. Weiterhin kommen hierfür Ketone, Phosphinoxide, Sulfoxide, Sulfone, Silan-Derivate und ähnliche Verbindungen in Frage, wie sie z.B. in der WO 05/040302 A1 beschrieben werden.

Die Strukturelemente aus der Gruppe 5 können unsubstituiert oder durch einen oder mehrere Reste R¹ substituiert sein. R¹ kann dabei die in Bezug auf die Einheit der allgemeinen Formel (III) angegebenen Bedeutungen annehmen. Ferner können die Strukturelemente der Gruppe 5 sowohl als Einheiten der allgemeinen Formel (I) als auch als Einheiten der allgemeinen Formel (II) eingesetzt werden, besonders bevorzugt werden sie jedoch als Einheiten der allgemeinen Formel (II) eingesetzt.

Die zuvor zitierten Druckschriften zur Beschreibung der funktionalen Strukturelemente werden in die vorliegende Anmeldung zu Offenbarungszwecken durch Referenz hierauf eingefügt.

In einer ersten bevorzugten Ausführungsform werden die Einheiten der allgemeinen Formel (I) ausgewählt aus:
- Einheiten, die Lochinjektions- und/oder Lochtransporteigenschaften aufweisen,
- Einheiten, die Elektroneninjektions- und/oder Elektronentransporteigenschaften aufweisen, und
- Einheiten, welche lichtemittierende Eigenschaften aufweisen und
die Einheiten der allgemeinen Formel (II) ausgewählt aus löslichkeitsvermittelnden Struktureinheiten der allgemeinen Formel (III).

In diesem Fall können die Einheiten der allgemeinen Formel (I) vorzugsweise über eine aromatische und/oder heteroaromatische Gruppe mit mindestens einer löslichkeitsvermittelnden Struktureinheit der allgemeinen Formel (III) verbunden sein. Gemäß einer bevorzugten Ausführungsform können die Einheiten der allgemeinen Formel (I) über ein Kohlenstoffatom eines aromatischen oder heteroaromatischen Ringsystems mit einer oder mehreren löslichkeitsvermittelnden Struktureinheiten der allgemeinen Formel (III) verbunden sein.

In einer zweiten bevorzugten Ausführungsform werden die Einheiten der allgemeinen Formel (I) ausgewählt aus löslichkeitsvermittelnden Struktureinheiten der allgemeinen Formel (III) und die Einheiten der allgemeinen Formel (II) ausgewählt aus:
- Einheiten, die Lochinjektions- und/oder Lochtransporteigenschaften aufweisen,
- Einheiten, die Elektroneninjektions- und/oder Elektronentransporteigenschaften aufweisen, und
- Einheiten, welche lichtemittierende Eigenschaften aufweisen.

Wie oben dargelegt sind die erfindungsgemäßen hyperverzweigten Polymere dadurch gekennzeichnet, dass mindestens eine Einheit der allgemeinen Formel (I) oder mindestens eine Einheit der allgemeinen Formel (II) ausgewählt ist aus einer löslichkeitsvermittelnden Einheit der allgemeinen Formel (III): 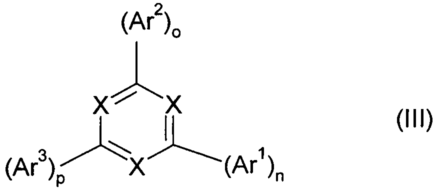 wobei
- Ar¹, Ar², Ar³: jeweils unabhängig voneinander eine Aryl- oder Heteroarylgruppe ist, welche mit einem oder mehreren beliebigen Resten R¹ substituiert sein kann,
- X: jeweils unabhängig voneinander N oder CR², vorzugsweise CH ist,
- R¹, R²: jeweils unabhängig voneinander Wasserstoff, eine geradkettige Alkyl-, Alkoxy- oder Thioalkoxygruppe mit 1 bis 40 C-Atomen oder eine verzweigte oder cyclische Alkyl-, Alkoxy- oder Thioalkoxy-gruppe mit 3 bis 40 C-Atomen ist oder eine Silylgruppe oder eine substituierte Ketogruppe mit 1 bis 40 C-Atomen, eine Alkoxy-carbonylgruppe mit 2 bis 40 C-Atomen, eine Aryloxycarbonyl-gruppe mit 7 bis 40 C-Atomen, eine Cyanogruppe (-CN), eine Carbamoylgruppe (-C(=O)NH₂), eine Haloformylgruppe (-C(=O)-X, worin X ein Halogenatom darstellt), eine Formylgruppe (-C(=O)-H), eine Isocyanogruppe, eine Isocyanatgruppe, eine Thiocyanat-gruppe oder eine Thioisocyanatgruppe, eine Hydroxygruppe, eine Nitrogruppe, eine CF₃-Gruppe, CI, Br, F, eine vernetzbare Gruppe oder ein substituiertes oder unsubstituiertes aromatisches oder heteroaromatisches Ringsystem mit 5 bis 60 Ringatomen, oder eine Aryloxy- oder Heteroaryloxygruppe mit 5 bis 60 Ringatomen, oder eine Kombination dieser Systeme ist, wobei eine oder mehrere der Gruppen R¹ und/oder R² ein mono- oder polycyclisches, aliphatisches oder aromatisches Ringsystem miteinander und/oder mit dem Ring, an dem die Gruppe R¹ gebunden ist, bilden können, und
- n, o, p: jeweils unabhängig voneinander, gleich oder verschieden 0 oder 1 sein können,
wobei gilt, dass die löslichkeitsvermittelnde Einheit der allgemeinen Formel (III) drei Bindungen zu anderen Einheiten des Polymeren aufweist, falls sie eine Einheit der allgemeinen Formel (I) darstellt, und dass die löslichkeitsvermittelnde Einheit der allgemeinen Formel (III) eine Bindung zu einer anderen Einheit des Polymeren aufweist, falls sie eine Einheit der allgemeinen Formel (II) darstellt.

Für den Fall, dass n = o = p = 0 ist, stellt die löslichkeitsvermittelnde Einheit vorzugsweise eine Einheit der beiden folgenden Formeln (I-IIIa) bzw. (II-IIIa) dar: 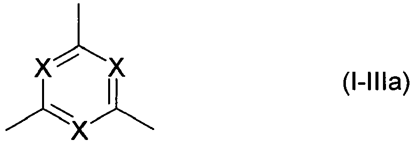 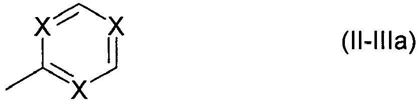 wobei X die in Bezug auf Formel (III) angegebenen Bedeutungen annehmen kann.

Besonders bevorzugt stellt in diesem Fall die löslichkeitsvermittelnde Einheit ein Einheit der beiden folgenden Formeln (I-IIIa1) bzw. (II-IIIa1) dar:

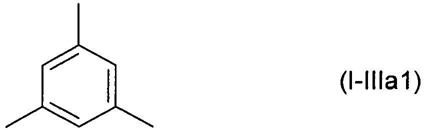

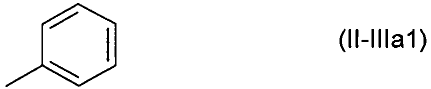

Für den Fall, dass n = 1 und o = p = 0 ist, stellt die löslichkeitsvermittelnde Einheit vorzugsweise eine Einheit der beiden folgenden Formeln (I-IIIb) bzw. (II-IIIb) dar: 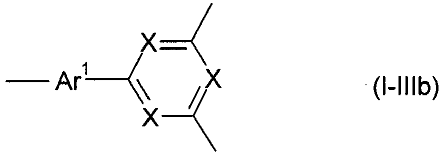 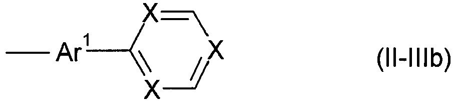 wobei Ar¹ und X die in Bezug auf Formel (III) angegebenen Bedeutungen annehmen können.

Besonders bevorzugt stellt in diesem Fall die löslichkeitsvermittelnde Einheit ein Einheit der beiden folgenden Formeln (I-IIIb1) bzw. (II-IIIb1) dar:

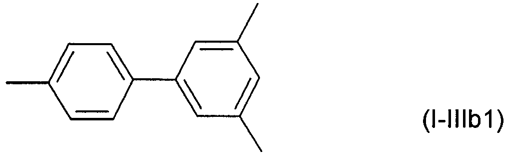

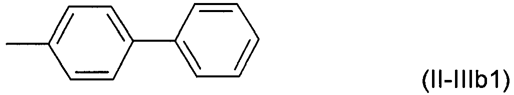

Für den Fall, dass n = 0 und o = p = 1 ist, stellt die löslichkeitsvermittelnde Einheit vorzugsweise eine Einheit der beiden folgenden Formeln (I-IIIc) bzw. (II-IIIc) dar: 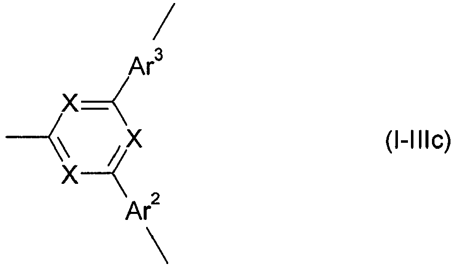 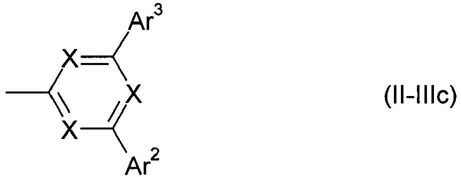 wobei Ar², Ar³ und X die in Bezug auf Formel (III) angegebenen Bedeutungen annehmen können.

Besonders bevorzugt stellt in diesem Fall die löslichkeitsvermittelnde Einheit ein Einheit der beiden folgenden Formeln (I-IIIc1) bzw. (II-IIIc1) dar:

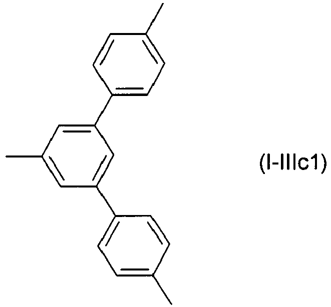

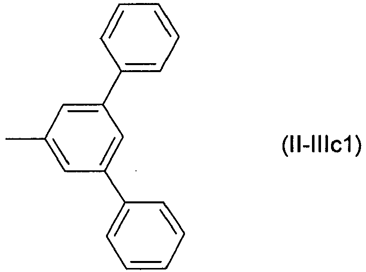

Für den Fall, dass n = o = p = 1 ist, stellt die löslichkeitsvermittelnde Einheit vorzugsweise eine Einheit der beiden folgenden Formeln (I-IIId) bzw. (II-IIId) dar: 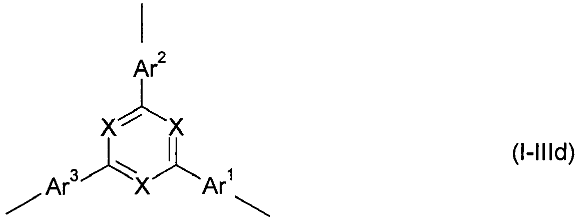 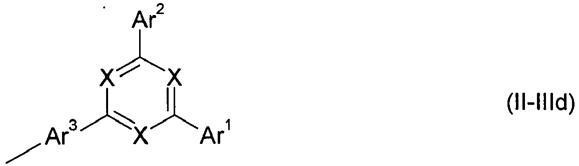 wobei Ar¹, Ar², Ar³ und X die in Bezug auf Formel (III) angegebenen Bedeutungen annehmen können.

Besonders bevorzugt stellt in diesem Fall die löslichkeitsvermittelnde Einheit ein Einheit der beiden folgenden Formeln (I-IIId1) bzw. (II-IIId1) dar:

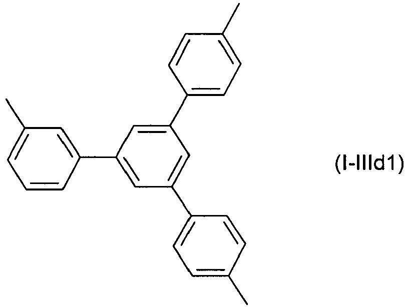

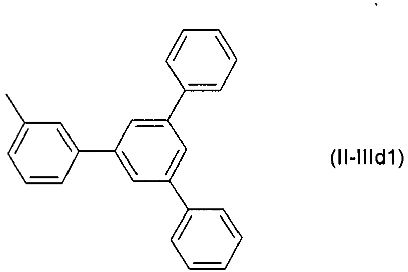

In den obigen Formeln (I-IIIa1), (II-IIIa1), (I-IIIb1), (II-IIIb1), (I-IIIc1), (II-IIIc1), (I-IIId1) und (II-IIId1) können die Phenylgruppen durch einen oder mehrere beliebige Reste R¹ substituiert sein. Die Reste R¹ können dabei die in Bezug auf Formel (III) angegebenen Bedeutungen annehmen.

Folglich entspricht beispielsweise die löslichkeitsvermittelnde Struktureinheit der allgemeinen Formel (II-IIId1) der allgemeinen Formel (II-IIId2) 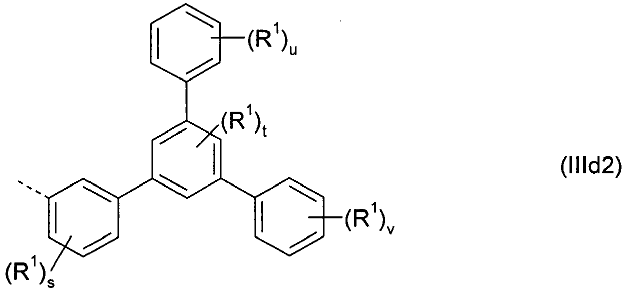 wobei
- R¹: jeweils unabhängig voneinander Wasserstoff, eine geradkettige Alkyl-, Alkenyl-, Alkoxy- oder Thioalkoxygruppe mit 1 bzw. 2 bis 40 C-Atomen oder eine verzweigte oder cyclische Alkyl-, Alkenyl-, Alkoxy- oder Thioalkoxygruppe mit 3 bis 40 C-Atomen ist oder eine Silylgruppe oder eine substituierte Ketogruppe mit 1 bis 40 C-Atomen, eine Alkoxycarbonylgruppe mit 2 bis 40 C-Atomen, eine Aryloxycarbonylgruppe mit 7 bis 40 C-Atomen, eine Formylgruppe (-C(=O)-H), eine CF₃-Gruppe, CI, Br, F, eine vernetzbare Gruppe oder ein substituiertes oder unsubstituiertes aromatisches oder heteroaromatisches Ringsystem mit 5 bis 60 Ringatomen, oder eine Aryloxy- oder Heteroaryloxygruppe mit 5 bis 60 Ringatomen, oder eine Kombination dieser Systeme ist, wobei eine oder mehrere der Gruppen R¹, R², R³ und/oder R⁴ ein mono- oder polycyclisches, aliphatisches oder aromatisches Ringsystem miteinander und/oder mit dem Ring, an dem die Gruppe R¹ gebunden ist, bilden können;
- s: 0, 1, 2, 3 oder 4 ist,
- t: 0, 1, 2 oder 3 ist, und
- u, v: jeweils unabhängig voneinander 0, 1, 2, 3, 4 oder 5 ist;
wobei die gestrichelte Bindung die Bindung an eine weitere Einheit des hyperverzweigten Polymeren andeutet.

Besonders bevorzugt stellen die Reste R¹ Wasserstoff (s, t, u und v = 0), eine geradkettige Alkyl- oder Alkoxygruppe mit 1 bis 20 C-Atomen oder eine verzweigte Alkyl- oder Alkoxygruppe mit 3 bis 20 C-Atomen dar.

Zu den besonders bevorzugten löslichkeitsvermittelnden Struktureinheiten der allgemeinen Formel (II-IIId2) gehören unter anderem die folgenden Strukturelemente: 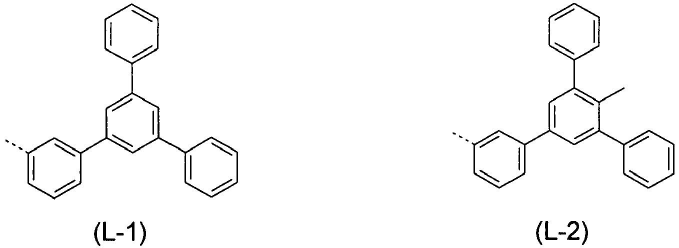 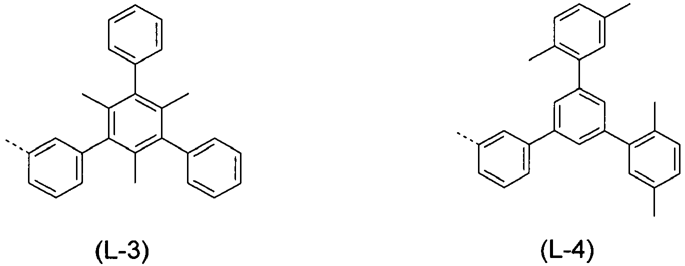 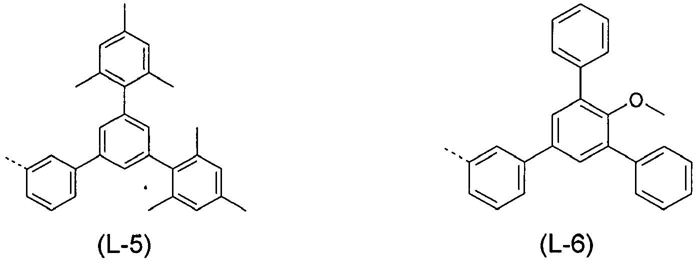 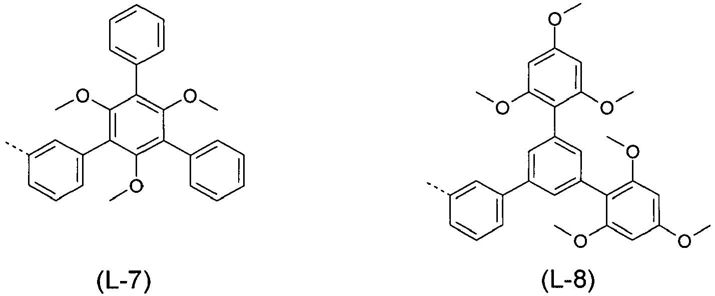 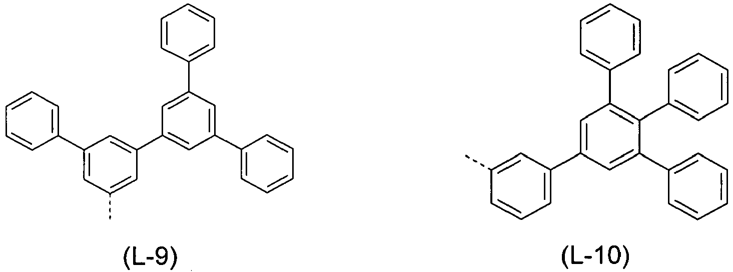 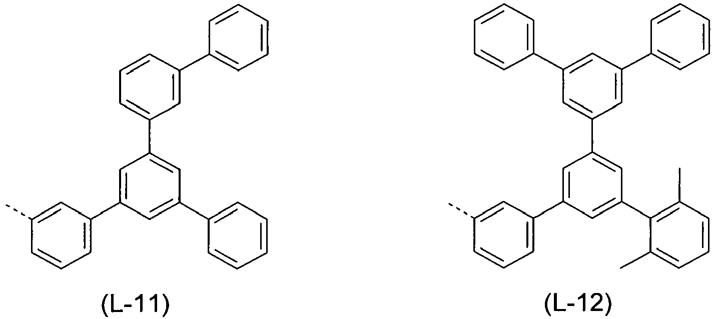 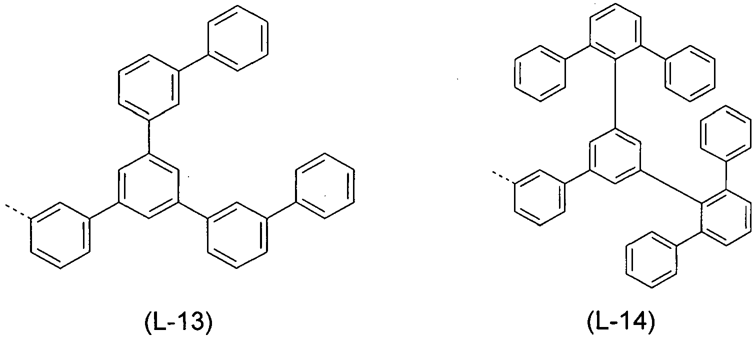 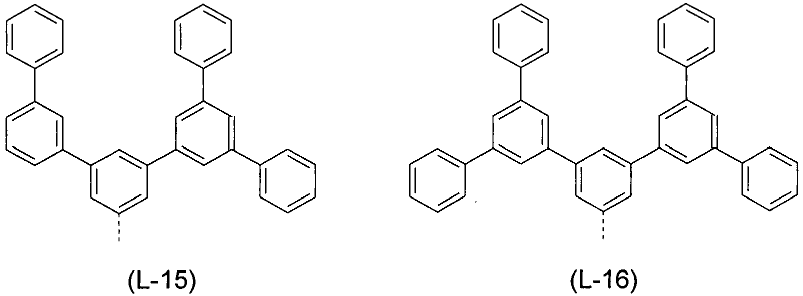 wobei die gestrichelte Bindung die Bindung eine weitere Einheit des hyperverzweigten Polymeren andeutet.

Als aromatisches oder heteroaromatisches Ringsystem mit 5 bis 60 Ringatomen, welches noch jeweils mit beliebigen Resten R substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Phenanthren, Pyren, Chrysen, Perylen, Fluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin, Benzothiadiazol, Benzanthren, Benzanthracen, Rubicen und Triphenylen. Besonders bevorzugt im Sinne der vorliegenden Erfindung ist Fluoren, Spirobifluoren, Indenofluoren, Anthracen, Phenanthren, Dihydrophenanthren und Carbazol.

Eine Arylgruppe im Sinne der vorliegenden Erfindung enthält 5 bis 60 C-Atome, eine Heteroarylgruppe im Sinne der vorliegenden Erfindung enthält 2 bis 60 C-Atome und mindestens ein Heteroatom, mit der Maßgabe, dass die Summe aus C-Atomen und Heteroatomen mindestens 5 ergibt. Die Heteroatome sind vorzugsweise ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, oder eine kondensierte Aryl- oder Heteroarylgruppe, beispielsweise Naphthalin, Anthracen, Phenanthren, Chinolin, Isochinolin, Benzothiophen, Benzofuran und Indol, verstanden.

In den Struktureinheiten der allgemeinen Formel (III) ist es ferner bevorzugt, dass R¹ und R², bzw. R¹, R², R³ und R⁴ bei jedem Auftreten unabhängig voneinander ausgewählt sind aus F, CI, Br, I, N(Ar)₂, N(R')₂, CN, NO₂, Si(R')₃, B(OR')₂, C(=O)Ar, C(=O)R', P(=O)(Ar)₂, P(=O)(R')₂, S(=O)Ar, S(=O)R', S(=O)₂Ar, S(=O)₂R', -CR'=CR'Ar, OSO₂R', einer geradkettigen Alkyl-, Alkoxy- oder Thioalkoxygruppe mit 1 bis 40 C-Atomen, vorzugsweise 1 bis 20 C-Atomen, oder einer verzweigten oder cyclischen Alkyl-, Alkoxy- oder Thioalkoxygruppe mit 3 bis 40 C-Atomen, vorzugsweise 3 bis 20 C-Atomen, die jeweils mit einem oder mehreren Resten R' substituiert sein kann, wobei eine oder mehrere nicht benachbarte CH₂-Gruppen durch R'C=CR', C=C, Si(R')₂, Ge(R')₂, Sn(R')₂, C=O, C=S, C=Se, C=NR', P(=O)(R'), SO, SO₂, NR', O, S oder CONR' ersetzt sein können und wobei ein oder mehrere H-Atome durch F, CI, Br, I, CN oder NO₂ ersetzt sein können, einer vernetzbaren Gruppe oder einem aromatischen oder heteroaromatischen Ringsystem mit 5 bis 60 Ringatomen, das jeweils durch einen oder mehrere Reste R' substituiert sein kann, oder einer Aryloxy- oder Heteroaryloxygruppe mit 5 bis 60 Ringatomen, die durch einen oder mehrere Reste R' substituiert sein kann, oder einer Kombination dieser Systeme, wobei zwei oder mehrere Substituenten R auch miteinander ein mono- oder polycyclisches, aliphatisches oder aromatisches Ringsystem bilden können, wobei R' jeweils unabhängig voneinander H oder ein aliphatischer oder aromatischer Kohlenwasserstoffrest mit 1 bis 20 C-Atomen und Ar eine Aryl- oder Heteroarylgruppen mit 2 bis 30 C-Atomen ist.

Die Struktureinheiten der allgemeinen Formel (III) können, wie zuvor dargelegt, eine oder mehrere vernetzbare Gruppen enthalten. "Vernetzbare Gruppe" bedeutet eine funktionelle Gruppe, die in der Lage ist, irreversibel zu reagieren. Dadurch wird ein vernetztes Material gebildet, das unlöslich ist. Die Vernetzung kann gewöhnlich durch Wärme oder durch UV-, Mikrowellen-, Röntgen- oder Elektronenstrahlung unterstützt werden. Hierbei kommt es bei der Vernetzung zu wenig Nebenprodukt-bildung. Zudem vernetzen die vernetzbaren Gruppen, die in den funktionalen Verbindungen enthalten sein können, sehr leicht, so dass geringere Energiemengen für die Vernetzung erforderlich sind (z.B. < 200°C bei der thermischen Vernetzung).

Beispiele für vernetzbare Gruppen sind Einheiten, die eine Doppelbindung, eine Dreifachbindung, eine Vorstufe, die zu einer in situ Bildung einer Doppel- bzw. Dreifachbindung in der Lage ist, oder einen heterocyclischen, additionspolymerisierbaren Rest enthalten. Vernetzbare Gruppen umfassen unter anderem Vinyl, Alkenyl, vorzugsweise Ethenyl und Propenyl, C₄-₂₀-Cycloalkenyl, Azid, Oxiran, Oxetan, Di(hydrocarbyl)amino, Cyanatester, Hydroxy, Glycidylether, C₁₋₁₀-Alkylacrylat, C₁₋₁₀-Alkylmeth-acrylat, Alkenyloxy, vorzugsweise Ethenyloxy, Perfluoralkenyloxy, vorzugsweise Perfluorethenyloxy, Alkinyl, vorzugsweise Ethinyl, Maleimid, Tri(C₁₋₄)-alkylsiloxy und Tri(C₁₋₄)-alkylsilyl. Besonders bevorzugt ist Vinyl und Alkenyl.

Im Rahmen der vorliegenden Erfindung werden unter einer Alkylgruppe mit 1 bis 40 C-Atomen, in der auch einzelne H-Atome oder CH₂-Gruppen durch die oben genannten Gruppen oder Reste R substituiert sein können, bevorzugt die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, Cyclopentyl, n-Hexyl, Cyclohexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl und Octinyl verstanden. Unter einer Alkoxygruppe mit 1 bis 40 C-Atomen werden vorzugsweise Methoxy, Trifluormethoxy, Ethoxy, n-Propoxy, i-Propoxy, n-Butoxy, i-Butoxy, s-Butoxy, t-Butoxy und 2-Methylbutoxy verstanden.

Ein weiterer Gegenstand der vorliegenden Erfindung sind die zur Herstellung der erfindungsgemäßen hyperverzweigten Polymere eingesetzten Monomere.

Die Erfindung stellt dazu eine Verbindung der allgemeinen Formel (VI) bereit, 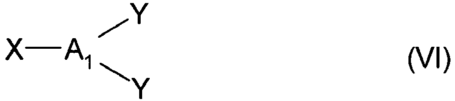 wobei
A₁ ein funktionales Strukturelement ist,
X eine Abgangsgruppe ist, die mit der Abgangsgruppe Y reagiert, und
Y Abgangsgruppen sind, die gleich oder verschieden, vorzugsweise gleich sind, und mit der Abgangsgruppe X reagieren.

Zur Herstellung der erfindungsgemäßen hyperverzweigten Polymere werden die funktionalisierten Verbindungen der allgemeinen Formel VI polymerisiert. Dies geschieht in Gegenwart von monofunktionellen Verbindungen, die in den erfindungsgemäßen hyperverzweigten Polymeren zu Einheiten der allgemeinen Formel (II) führen.

Geeignete Polymerisationsreaktionen sind dem Fachmann bekannt und in der Literatur beschrieben. Besonders geeignete und bevorzugte Polymerisations- und Kupplungsreaktionen, die alle zu C-C-Verknüpfungen führen, sind solche gemäß SUZUKI, YAMAMOTO, STILLE, HECK, NEGISHI, SONOGASHIRA oder HIYAMA. Die C-C-Verknüpfungen werden besonders bevorzugt über eine SUZUKI-Kupplung durchgeführt.

Wie die Polymerisation nach diesen Methoden durchgeführt werden kann und wie die Polymere dann vom Reaktionsmedium abgetrennt und gereinigt werden können, ist dem Fachmann bekannt und in der Literatur, beispielsweise in der WO 03/048225 und der WO 04/037887, im Detail beschrieben.

In einer ersten besonders bevorzugten Ausführungsform ist X ausgewählt aus Halogenid oder Triflat und Y ausgewählt aus Boronsäure oder Boronsäureester. In einer zweiten besonders bevorzugten Ausführungsform ist X ausgewählt aus Boronsäure oder Boronsäureester und Y ausgewählt aus Halogenid oder Triflat. Das Halogenid ist dabei ausgewählt aus F, Cl, Br und I. Besonders bevorzugt ist das Halogenid Brom.

In einer weiteren Ausführungsform der vorliegenden Erfindung werden die erfindungsgemäßen hyperverzweigten Polymere nicht als Reinsubstanz, sondern als Mischung (Blend) zusammen mit weiteren beliebigen polymeren, oligomeren, dendritischen oder niedermolekularen Substanzen verwendet. Diese können z.B. die elektronischen Eigenschaften verbessern oder selber emittieren. Als "Mischung" oder "Blend" wird vor- und nachstehend eine Mischung enthaltend mindestens eine polymere Komponente bezeichnet.

Ein weiterer Gegenstand der vorliegenden Erfindung ist somit eine Polymermischung (Blend), die ein oder mehrere erfindungsgemäße hyperverzweigten Polymere, sowie eine oder mehrere weitere polymere, oligomere, dendritische oder niedermolekulare Substanzen enthält.

Gegenstand der Erfindung sind weiterhin Lösungen und Formulierungen aus einem oder mehreren erfindungsgemäßen hyperverzweigten Polymere oder Mischungen in einem oder mehreren Lösungsmitteln. Wie solche Lösungen hergestellt werden können, ist dem Fachmann bekannt und beispielsweise in der WO 02/072714 A1, der WO 03/019694 A2 und der darin zitierten Literatur beschrieben.

Diese Lösungen können verwendet werden, um dünne Polymerschichten herzustellen, zum Beispiel durch Flächenbeschichtungsverfahren (z.B. Spin-coating) oder durch Druckverfahren (z.B. InkJet Printing).

Hyperverzweigte Polymere enthaltend Struktureinheiten der allgemeinen Formel (I) und (II), welche eine oder mehrere polymerisierbare, und damit vernetzbare Gruppen enthalten, eignen sich besonders zur Herstellung von Filmen oder Beschichtungen, insbesondere zur Herstellung von strukturierten Beschichtungen, z.B. durch thermische oder lichtinduzierte in-situ-Polymerisation und in-situ-Vernetzung, wie beispielsweise in-situ-UV-Photopolymerisation oder Photopatterning. Besonders bevorzugt für solche Anwendungen sind erfindungsgemäße hyperverzweigte Polymere mit einer oder mehreren polymerisierbaren Gruppen, ausgewählt aus Acrylat, Methacrylat, Vinyl, Epoxy und Oxetan. Dabei können sowohl entsprechende hyperverzweigte Polymere in Reinsubstanz verwendet werden, es können aber auch Formulierungen oder Blends dieser hyperverzweigten Polymere wie oben beschrieben verwendet werden. Diese können mit oder ohne Zusatz von Lösungsmitteln und/oder Bindemitteln verwendet werden. Geeignete Materialien, Verfahren und Vorrichtungen für die oben beschriebenen Methoden sind z.B. in der WO 2005/083812 A2 offenbart. Mögliche Bindemittel sind beispielsweise Polystyrol, Polycarbonat, Poly-acrylat, Polyvinylbutyral und ähnliche, optoelektronisch neutrale Polymere.

Geeignete und bevorzugte Lösungsmittel sind beispielsweise Toluol, Anisol, Xylole, Methylbenzoat, Dimethylanisole, Trimethylbenzole, Tetralin, Dimethoxybenzole, Tetrahydrofuran, Chlorbenzol und Dichlorbenzol sowie Gemische derselben.

Die erfindungsgemäßen hyperverzweigten Polymere, Mischungen und Formulierungen können in elektronischen oder elektrooptischen Vorrichtungen bzw. zu deren Herstellung verwendet werden.

Ein weiterer Gegenstand der vorliegenden Erfindung ist somit die Verwendung der erfindungsgemäßen hyperverzweigten Polymere, Mischungen und Formulierungen in elektronischen oder elektrooptischen Vorrichtungen, vorzugsweise in organischen bzw. polymeren organischen Elektrolumineszenzvorrichtungen (OLED, PLED), organischen Feld-Effekt-Transistoren (OFETs), organischen integrierten Schaltungen (O-ICs), organischen Dünnfilmtransistoren (TFTs), organischen Solarzellen (O-SCs), organischen Laserdioden (O-Laser), organischen photovoltaischen (OPV) Elementen oder Vorrichtungen oder organischen Photorezeptoren (OPCs), besonders bevorzugt in organischen bzw. polymeren organischen Elektrolumineszenzvorrichtungen (OLED, PLED), insbesondere in polymeren organischen Elektrolumineszenzvorrichtungen (PLED).

Wie OLEDs bzw. PLEDs hergestellt werden können, ist dem Fachmann bekannt und wird beispielsweise als allgemeines Verfahren ausführlich in der WO 2004/070772 A2 beschrieben, das entsprechend für den Einzelfall anzupassen ist.

Wie oben beschrieben, eignen sich die erfindungsgemäßen hyperverzweigten Polymere ganz besonders als Elektrolumineszenzmaterialien in derart hergestellten PLEDs oder Displays.

Als Elektrolumineszenzmaterialien im Sinne der vorliegenden Erfindung gelten Materialien, die als aktive Schicht Verwendung finden können. Aktive Schicht bedeutet, dass die Schicht befähigt ist, bei Anlegen eines elektrischen Feldes Licht abzustrahlen (lichtemittierende Schicht) und/oder dass sie die Injektion und/oder den Transport der positiven und/oder negativen Ladungen verbessert (Ladungsinjektions- oder Ladungstransportschicht).

Ein bevorzugter Gegenstand der vorliegenden Erfindung ist daher auch die Verwendung der erfindungsgemäßen hyperverzweigten Polymere oder Blends in einer PLED, insbesondere als Elektrolumineszenzmaterial.

Gegenstand der vorliegenden Erfindung sind ferner elektronische oder optoelektronische Vorrichtungen, vorzugsweise organische bzw. polymere organische Elektrolumineszenzvorrichtungen (OLED, PLED), organische Feld-Effekt-Transistoren (OFETs), organische integrierte Schaltungen O-ICs), organische Dünnfilmtransistoren (TFTs), organische Solarzellen (O-SCs), organische Laserdioden (O-Laser), organische photovoltaische (OPV) Elemente oder Vorrichtungen oder organische Photorezeptoren (OPCs), besonders bevorzugt organische bzw. polymere organische Elektrolumineszenzvorrichtungen, insbesondere polymere organische Elektrolumineszenzvorrichtungen, mit einer oder mehreren aktiven Schichten, wobei mindestens eine dieser aktiven Schichten ein oder mehrere erfindungsgemäße hyperverzweigte Polymere enthält. Die aktive Schicht kann beispielsweise eine lichtemittierende Schicht, eine Ladungstransportschicht und/oder eine Ladungsinjektionsschicht sein.

Im vorliegenden Anmeldungstext und auch in den im Weiteren folgenden Beispielen wird hauptsächlich auf die Verwendung der erfindungsgemäßen hyperverzweigten Polymere in Bezug auf PLEDs und entsprechende Displays abgezielt. Trotz dieser Beschränkung der Beschreibung ist es für den Fachmann ohne weiteres erfinderisches Zutun möglich, die erfindungsgemäßen hyperverzweigten Polymere als Halbleiter auch für die weiteren, oben beschriebenen Verwendungen in anderen elektronischen Vorrichtungen zu benutzen.

Die folgenden Beispiele sollen die Erfindung erläutern, ohne sie einzuschränken. Insbesondere sind die darin beschriebenen Merkmale, Eigenschaften und Vorteile der dem betreffenden Beispiel zu Grunde liegenden definierten Verbindungen auch auf andere, nicht im Detail aufgeführte, aber unter den Schutzbereich der Ansprüche fallende Verbindungen anwendbar, sofern an anderer Stelle nichts Gegenteiliges gesagt wird.

### Beispiele

### Beispiel 1

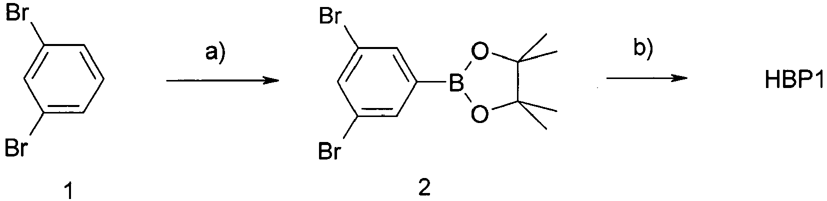

### A) Herstellung des Monomeren (3,5-Dibromphenyl)boronester (2)

19,5 g (82,7 mmol) 1,3-Dibrombenzol **(1)** und 24,0 g (94,5 mmol) Bis(pinakolato)diboron werden in 150 ml Cyclohexan suspendiert. Zu dieser Suspension werden 1,50 g (5,59 mmol) dtbpy und 500 mg (754 µmol) [Ir(OMe)COD]₂ gegeben und 16 Stunden bei 80°C gerührt. Nach dem Erkalten wird das dunkelbraune Gemisch auf 300 ml Eiswasser gegeben und dreimal mit je 300 ml Dichlormethan extrahiert. Die organische Phase wird abgetrennt, mit Wasser und Brine gewaschen, über Na₂SO₄ getrocknet und anschließend zur Trockene eingeengt. Das Rohprodukt wird säulenchromatographisch an Kieselgel (CH₂Cl₂) gereinigt. **2** wird als farbloser Feststoff in einer Ausbeute von 85 % (24,8 g, 68,5 mmol) erhalten.

**¹H NMR (500 MHz, CDCl₃)** *δ* = 7.84 (d, *J* = 1.9 Hz, 2H), 7.74 (t, *J* = 1.9 Hz, 1 H), 1.34 (s, 12H).
**¹³C NMR (126 MHz, CDCl₃)** *δ* = 136.2, 135.6, 122.5, 84.2, 24.5. **APLI-HRMS *m*/*z* (C₁₂H₁₅BBr₂O₂):** berechnete Masse: 359.9526 [M]⁺, gefundene Masse: 359.9537 [M]⁺.

Der Katalysator Di-µ-methoxybis(1,5-cyclooctadiene)diiridium [Ir(OMe)COD]₂ und der verwendete Ligand 4,4'-Di-tert-butyl-2,2'-bipyridin (dtbpy) sind in der folgenden Abbildung dargestellt.

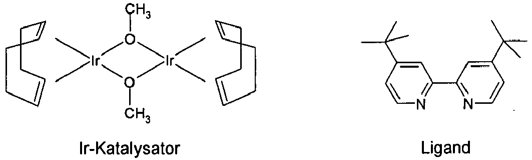

### B) Polymerisation des Monomeren (3,5-Dibromphenyl)boronester (2)

5,53 mmol Monomer **(2)** und 12,2 mmol K₃PO₄ als Base werden in einem Toluol/THF/Wasser Gemisch (8 ml Toluol, 32 ml THF und 20 ml H₂O), 30 Minuten entgast. Es werden 5,00 mg (22 µmol) Pd(OAc)₂ und 42,0 mg (134 µmol) P(*o*-tol)₃ zugegeben und bei 100°C Badtemperatur erhitzt. Bereits nach wenigen Minuten scheidet sich am Thermometer ein gelber Feststoff ab. Nach mehrmaligem Lösen in THF und Ausfällen in Methanol, wird **HBP 1** mit Mₙ = 10300, M_{w} = 16400 und einer Polydispersität von PD = 1,6 erhalten. ICP-MS-Messungen ergeben einen Bromgehalt von 51%, was einer Brom-Endgruppe pro Phenyleinheit entspricht.

### Beispiel 2

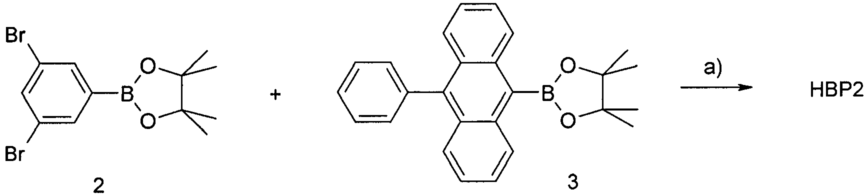

Analog Beispiel 1, Schritt 2, werden 2,76 mmol Monomer **(2)** in drei separaten Ansätzen mit jeweils 3,02 mmol eines Anthracenboronesters **(3)** als Endcapper und 12,2 mmol K₃PO₄ in 8 ml Toluol, 32 ml THF und 20 ml H₂O, 30 Minuten entgast. Es werden 5,00 mg (22 µmol) Pd(OAc)₂ und 42,0 mg (134 µmol) P(*o*-tol)₃ zugegeben und bei 100 °C erhitzt.

Die durch GPC erhaltenen Gewichtsmittel der erhaltenen Polymere **HBP 2** liegen zwischen 8000 und 11500 g/mol im höher molekularen Bereich, ein weiterer Peak wird zwischen 400 und 600 g/mol detektiert, was für ein zusätzliches oligomeres System spricht.

### Beispiel 3

### A) Herstellung des Biphenylmonomeren (7)

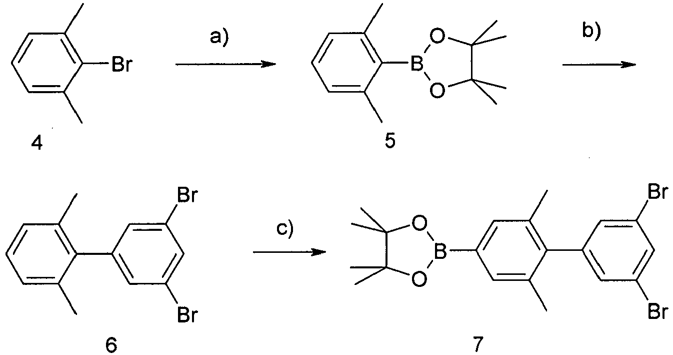

### 1. Schritt (5)

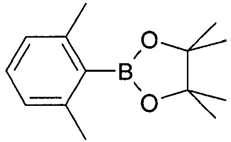

27,8 g (150 mmol) 2-Brom-*m*-xylol **(4),** 41,0 g (161 mmol) Bis(pinakolato)-diboron und 43,0 g (438 mmol) KOAc werden in 1 l DMSO suspendiert. Zu dieser Suspension werden 12,0 g (15,0 mmol) Pd(dppf)₂Cl₂ gegeben und 16 Stunden bei 80°C gerührt. Nach Erkalten werden 1 I Dichlormethan und 2 I Wasser hinzugegeben, die wässrige Phase wird zweimal mit je 300 ml Dichlormethan extrahiert, die vereinigten organischen Phasen werden mit Wasser und Brine gewaschen, über Na₂SO₄ getrocknet und anschließend zur Trockene eingeengt. Das Rohprodukt wird säulenchromatographisch an Kieselgel (CH₂Cl₂) gereinigt. **5** wird als farbloser Feststoff in einer Ausbeute von 70 % (24,4 g, 105 mmol) erhalten.

**¹H NMR (500 MHz, CDCl₃)** *δ* = 7.12 (t, *J* = 7.6 Hz, 1 H), 6.94 (d, *J* = 7.6 Hz, 2H), 2.40 (s, 6H), 1.39 (s, 12H).
**¹³C NMR (126 MHz, CDCl₃)** *δ* = 141.4, 128.8, 126.1, 83.3, 24.6, 21.9. **APLI-HRMS *m*/*z* (C₁₄H₂₁BO₂):** berechnete Masse: 232.1629 [M]⁺, gefundene Masse: 232.1627 [M]⁺.

### 2. Schritt (6)

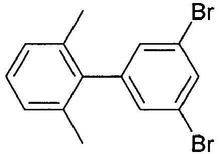

19,4 g (53,6 mmol) 1,3-Dibrom-5-iodbenzol, 13,3 g (57,3 mmol) **5** und 37,0 g (268 mmol) K₂CO₃ werden in 400 ml Toluol und 350 ml Wasser suspendiert. Zu dieser Suspension werden 980 mg (848 µmol) Pd(PPh₃)₂Cl₂ gegeben und 16 Stunden unter Rückfluss erhitzt. Nach dem Erkalten werden die Phasen getrennt, die vereinigten organischen Phasen mit Wasser und Brine gewaschen, über Na₂SO₄ getrocknet und anschließend zur Trockene eingeengt. Das Rohprodukt wird säulenchromatographisch an Kieselgel (*n*-Heptan) gereinigt. **6** wird als farbloser Feststoff in einer Ausbeute von 83 % (15,2 g, 44,7 mmol) erhalten.

**¹H NMR (500 MHz, CDCl₃)** *δ* = 7.67 (t, *J* = 1.8 Hz, 1 H), 7.27 (d, *J* = 1.8 Hz, 2H), 7.18 (dd, *J* = 8.1 Hz, *J* = 7.0 Hz, 1 H), 7.10 (d, *J* = 7.6 Hz, 2H), 2.05 (s, 6H).
**¹³C NMR (126 MHz, CDCl₃)** *δ* = 144.4, 138.6, 135.4, 132.1, 130.6, 127.5, 127.2, 122.7, 20.4.
**EI-MS *m*/*z* (C₁₄H₁₂Br₂):** berechnete Masse: 337.931 [M]⁺, gefundene Masse: 337.930 [M]⁺.

### 3. Schritt (7)

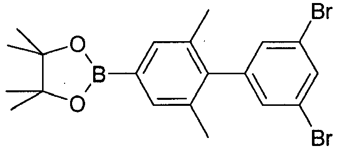

29,2 g (85,9 mmol) **6** und 32,9 g (130 mmol) Bis(pinakolato)diboron werden in 200 ml Cyclohexan suspendiert. Zu dieser Suspension werden 2,0 g (7,45 mmol) dtbpy und 500 mg (754 µmol) [Ir(OMe)COD]₂ gegeben und 16 Stunden bei 80°C gerührt. Nach dem Erkalten wird das dunkelbraune Gemisch auf 400 ml Eiswasser gegeben und dreimal mit je 300 ml Ethylacetat extrahiert. Die organische Phase wird abgetrennt, mit Wasser und Brine gewaschen, über Na₂SO₄ getrocknet und anschließend zur Trockene eingeengt. Das Rohprodukt wird dreimal heiß in Acetonitril ausgerührt und zweimal aus Acetonitril umkristallisiert. **7** wird als farbloser Feststoff in einer Ausbeute von 49 % (19,7 g, 42,3 mmol) erhalten.

**¹H NMR (500 MHz, CDCl₃)** *δ* = 7.66 (t, *J* = 1.7 Hz, 1 H), 7.55 (s, 2H), 7.23 (d, *J =* 1.7 Hz, 2H), 2.04 (s, 6H), 1.36 (s, 12H).
**¹³C NMR (126 MHz, CDCl₃)** *δ* = 144.3, 141.5, 134.7, 133.5, 132.1, 130.3, 122.7, 83.5, 24.5, 20.2.
**ESI-HRMS *m*/*z* (C₂₀H₂₃BBr₂O₂):** berechnete Masse: 465.0231 [M+H]⁺, gefundene Masse: 465.0229 [M+H]⁺.

### B) Polymerisation des Biphenylmonomeren (7)

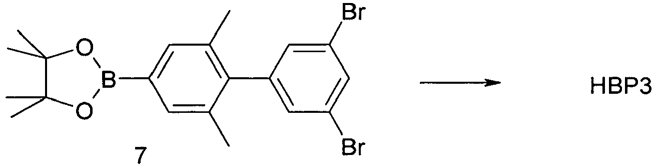

5,53 mmol Monomer **(7)** und 12,2 mmol K₃PO₄ als Base werden in einem Toluol/THF/Wasser Gemisch (8 ml Toluol, 32 ml THF und 20 ml H₂O), 30 Minuten entgast. Zur Evaluierung geeigneter Polymerisationsbedingungen wird das Biphenyl-Monomer **(7)** bei unterschiedlichen Bedingungen polymerisiert. Dabei wird der Einfluss unterschiedlicher Katalysatoren und Basen in unterschiedlichen Lösungsmitteln untersucht bei gleichbleibender Reaktionszeit von 5 Stunden und gleichbleibender Reaktionstemperatur von 100°C (Tabelle 1).

**Tabelle 1: Einfluss verschiedener Reaktionsbedingungen auf das Molekulargewicht (M_{w}, Mₙ, PD).**

| **HBP 3** | **Base** | **Kat + Ligand** | **Lösemittel** | | **Mn** | **M_{w}** | **PD** |
|---|---|---|---|---|---|---|---|
| | | Pd(OAc)₂ P(*o*-tol)₃ | Tol | 2 | | | |
| **a** | K₃PO₄ | | THF | 8 | 30300 | 53200 | 1.8 |
| | | | H₂O | 5 | | | |
| | | Pd(OAc)₂ P(*o*-tol)₃ | Tol | 2 | | | |
| **b** | NaHCO₃ | | THF | 8 | 13300 | 22500 | 1.7 |
| | | | H₂O | 5 | | | |
| **c** | NaHCO₃ | Pd(OAc)₂ | THF | 5 | 9800 | 17800 | 1.8 |
| | | P(*o*-tol)₃ | H₂O | 1 | | | |
| **d** | Na₂CO₃ | Pd(OAc)₂ | THF | 5 | 13500 | 25800 | 1.9 |
| | | P(*o*-tol)₃ | H₂O | 1 | | | |
| **e** | K₃PO₄ | Pd(OAc)₂ | THF | 5 | 13600 | 23300 | 1.7 |
| | | P(*o*-tol)₃ | H₂O | 1 | | | |
| **f** | NaHCO₃ | Pd(PPh₃)₄ | THF | 5 | 8100 | 31400 | 3.9 |
| | | | H₂O | 1 | | | |
| **g** | Na₂CO₃ | Pd(PPh₃)₄ | THF | 5 | 11500 | 38200 | 3.3 |
| | | | H₂O | 1 | | | |
| **h** | K₃PO₄ | Pd(PPh₃)₄ | THF | 5 | 4100 | 7200 | 1.8 |
| | | | H₂O | 1 | | | |
| **i** | KF | Pd(OAc)₂ S-Phos⁸⁴ | THF | | 2800 | 3400 | 1.2 |
| **j** | KF | Pd(OAc)₂ P(*t*-Bu)₃ | THF | | Kein Polymer | | |

Ziel ist es ein möglichst hohes Molekulargewicht bei geringer Polydispersität zu erreichen. Bleibt das Polymer während der Polymerisation in Lösung, werden in der Regel höhere Molekulargewichte erzielt, da ausgefallenes Polymer nicht weiter polymerisiert.

Wie der Tabelle zu entnehmen ist, werden mit Pd(OAc)₂/P(*o*-tol)₃ und Base in Toluol/THF/Wasser (2 : 8 : 5) die höchsten Molekulargewichte bei ähnlich geringer Polydispersität erreicht **(HBP 3a,b).**

Aus diesem Grund werden die weiteren Polymerisationen mit Endgruppen mit diesem Katalysator-System (Kombination aus Pd(OAc)₂ und P(*o*-tol)₃) in Toluol/THFNVasser (2 : 8 : 5) durchgeführt.

### Beispiel 4

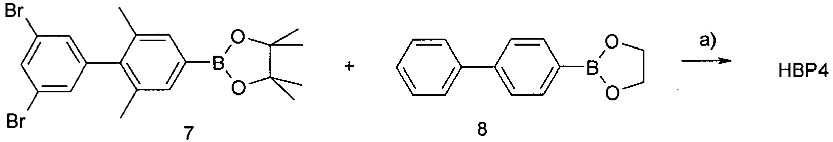

Analog Beispiel 3 werden 2,76 mmol Monomer **(7)**, 3,02 mmol 2-Biphenyl-4-yl-[1,3,2]dioxa-borolan **(8)** als Endcapper und 12,2 mmol K₃PO₄ als Base in einem Toluol/THF/Wasser Gemisch (8 ml Toluol, 32 ml THF und 20 ml H₂O), 30 Minuten entgast. Es werden 5,00 mg (22 µmol) Pd(OAc)₂ und 42,0 mg (134 µmol) P(*o*-tol)₃ zugegeben und bei 100°C erhitzt. Bereits nach 3 Stunden Reaktionszeit wird ein hochmolekulares hyperverzweigtes Polymer **HBP 4** erhalten, das nicht ausfällt.

Das Polymer **HBP4** weist eine Polydispersität von PD = 1,8 sowie die folgenden Molekulargewichte auf: Mₙ = 19600 und M_{w} = 36200.

### Beispiel 5

### A) Herstellung des Monomeren (9)

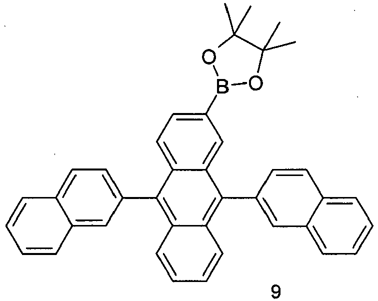

In einem Kolben mit Wasserabscheider werden 25,2 g (53,1 mmol) (9,10-Di-2-naphthyl)-2-anthracenboronsäure mit 12,5 g (106 mmol) wasserfreiem Pinakol in 700 ml Toluol 4 Stunden unter Rückfluss erhitzt. Nach dem Erkalten wird das Lösungsmittel unter vermindertem Druck entfernt und das Rohprodukt aus *n*-Heptan/THF umkristallisiert. Monomer **(9)** wird als gelber Feststoff in einer Ausbeute von 94 % (27,9 g, 50,1 mmol) erhalten.

**¹H NMR (500 MHz, CDCl₃)** *δ* = 8.31 (s, 1 H), 8.13 - 7.92 (m, 8H), 7.74-7.70 (m, 2H), 7.70 - 7.57 (m, 8H), 7.34 - 7.27 (m, 2H), 1.26 (d, *J* = 2.4 Hz, 12H).
**¹³C NMR (126 MHz, CDCl₃)** *δ* = 138.3, 136.9, 136.7, 136.5, 135.6, 133.5, 133.5, 132.9, 132.8, 131.1, 130.8, 130.5, 130.3, 129.9, 129.7, 129.4, 129.3, 128.4, 128.2, 128.0, 128.0, 128.0, 127.4, 127.0, 126.4, 126.3, 126.2, 126.1, 126.0, 125.5, 125.0, 83.8, 24.8.
**ESI-HRMS *m*/*z* (C₄₀H₃₃BO₂):** berechnete Masse: 556.2573 [M]⁺, gefundene Masse: 557.2633 [M+H]⁺.

### B) Herstellung des Polymeren

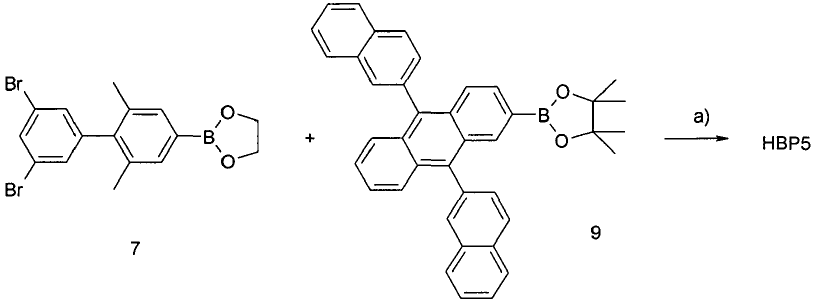

Analog Beispiel 3 werden 2,76 mmol Monomer **(7)**, 3,02 mmol Anthracenyl-Boronester **(9)** als Endcapper und 12,2 mmol K₃PO₄ als Base in einem Toluol/THF/Wasser Gemisch (8 ml Toluol, 32 ml THF und 20 ml H₂O), 30 Minuten entgast. Es werden 5,00 mg (22 µmol) Pd(OAc)₂ und 42,0 mg (134 µmol) P(*o*-tol)₃ zugegeben und bei 100°C erhitzt. Nach 6 Stunden Reaktionszeit wird **HBP 5** isoliert.

Das Polymer **HBP5** weist eine Polydispersität von PD = 1,6 sowie die folgenden Molekulargewichte auf: Mₙ = 7800 und M_{w} = 12800.

### Beispiel 6

### A) Herstellung des Monomeren (11)

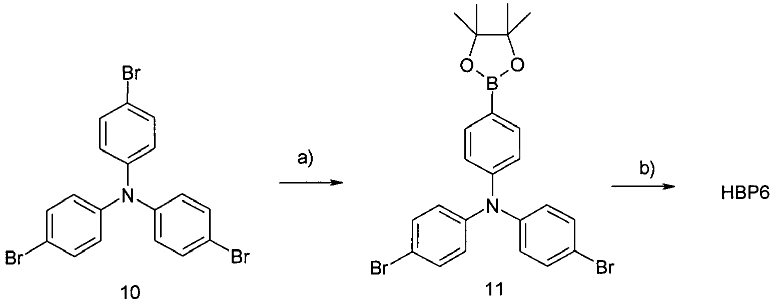

Eine Suspension von 60,0 g (124 mmol) Tris(4-Bromphenyl)amin in 1200 ml Diethylether wird bei -78°C unter gutem Rühren tropfenweise mit 79,0 ml (126 mmol) *n*-Butyllithium (2,5 M in *n*-Hexan) versetzt und 1 Stunde nachgerührt. Die Lösung wird unter gutem Rühren mit 43,0 ml (379 mmol) Trimethylborat versetzt, 1 Stunde bei -78°C nachgerührt, dann auf Raumtemperatur erwärmt. Die Reaktionsmischung wird auf 1,5 l Eiswasser gegeben und mit Ethylacetat extrahiert. Die vereinigten organischen Phasen werden einmal mit Wasser, einmal mit NH₄Cl-Lösung und einmal mit Brine gewaschen, über Na₂SO₄ getrocknet und abschließend zur Trockene eingeengt. Die erhaltene Boronsäure wird mit 21,0 g (178 mmol) Pinakol in 800 ml Toluol 5 Stunden am Wasserabscheider refluxiert. Das Rohprodukt wird säulenchromatographisch an Kieselgel (*n*-Heptan/Ethylacetat, 10:1) gereinigt und dreimal aus *n*-Heptan umkristallisiert. **11** wird als farbloser Feststoff in einer Ausbeute von 39 % (25,7 g, 48,6 mmol) erhalten.

**¹H NMR (500 MHz**, **CDCl₃)** *δ* = 7.72 - 7.64 (m, 2H), 7.39 - 7.31 (m, 4H), 7.03 - 6.97 (m, 2H), 6.97 - 6.91 (m, 4H), 1.33 (s, 12H).
**¹³C NMR (126 MHz, CDCl₃)** *δ* = 149.62, 146.17, 136.13, 132.48, 126.15, 122.50, 116.18, 83.75, 24.89.
**APCI-HRMS *m*/*z* (C₂₄H₂₄BBr₂NO₂)**: berechnete Masse: 528.0340 [M+H]⁺, gefundene Masse: 528.0327 [M+H]⁺.

### B) Polymerisation des Monomeren (11)

5,53 mmol Monomer **(11)** und 12,2 mmol K₃PO₄ als Base werden in einem Toluol/THF/Wasser Gemisch (8 ml Toluol, 32 ml THF und 20 ml H₂O), 30 Minuten entgast. Es werden 5,00 mg (22 µmol) Pd(OAc)₂ und 42,0 mg (134 µmol) P(*o*-tol)₃ zugegeben und 1,5 Stunden bei 100°C Badtemperatur erhitzt.

Die Umsetzung von **(11)** ergibt **HBP 6** als aminhaltiges Polymer. **HBP 6** kann als polymeres Benzidin verstanden werden, welches als Lochtransportmaterial in der OLED eingesetzt werden kann.
Mit einer Polydispersität von PD = 1.6 und einem Molekulargewicht von Mₙ = 16000 ist ein hyperverzweigtes System mit 50 Wiederholungseinheiten enstanden.

### Beispiel 7

### Polymerisation des Monomeren (11) mit verschiedenen Endgruppen

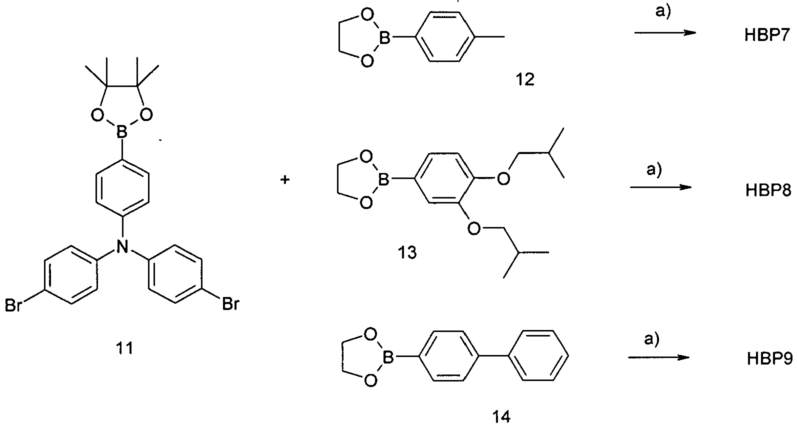

Es werden jeweils 2,76 mmol Monomer **(11)**, 3,02 mmol eines Endcappers und 12,2 mmol K₃PO₄ als Base in einem Toluol/THF/Wasser Gemisch (8 ml Toluol, 32 ml THF und 20 ml H₂O), 30 Minuten entgast. Die verwendeten Endcapper sind: 2-*p*-Tolyl[1,3,2]dioxaborolan **(12),** 2-(3,4-Diiso-butoxyphenyl)-[1,3,2]dioxaborolan **(13)** sowie 2-*p*-Biphenyl[1,3,2]-dioxaborolan **(14).** Es werden 5,00 mg (22 µmol) Pd(OAc)₂ und 42,0 mg (134 µmol) P(*o*-tol)₃ zugegeben und bei 100°C für 1,5 Stunden erhitzt.

Die Molekulargewichte Mₙ und M_{w} sowie die Polydispersität PD der Polymeren HBP7, HBP8 und HBP9a sind in Tabelle 2 aufgelistet.

Zusätzlich wird die Umsetzung des Monomeren **(11)** mit der Endgruppe **(14)** nochmals bei 1,5-facher Verdünnung wiederholt **(HBP9b).**

Die Polymere zeigen alle breitere Molekulargewichtsverteilungen als das Homopolymer **HBP 6.**

**Tabelle 2: Molekulargewichte, Polydispersitäten und Bromgehalt von HBP 7, HBP 8, HBP 9a, HBP 9b**

| | **Endgruppe** | **Mn** | **M_{w}** | **PD** |
|---|---|---|---|---|
| **HBP 7** | 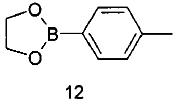 | 5100 | 19200 | 3.8 |
| **HBP 8** | 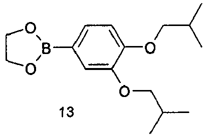 | 14600 | 37700 | 2.6 |
| **HBP 9a** | 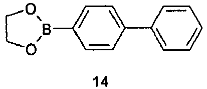 | 12700 | 36200 | 2.9 |
| **HBP 9b** | 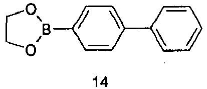 | 3800 | 10900 | 2.9 |

### Beispiel 8

### Polymerisation des Monomeren (11) mit der Endgruppe (15)

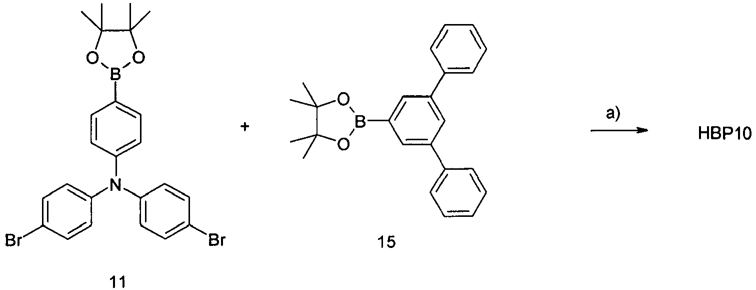

2,12 g (4,00 mmol) Monomer **(11)** und 4,05 mmol Endcapper **(15)** werden mit einem Toluol/Dioxan/Wasser-Gemisch (jeweils 40 ml) mit 17,6 mmol K₃PO₄ als Base für 30 Minuten entgast. Es werden dann 55,8 mg (80,0 µmol) des Katalysator-Systems Chloro{[RuPhos][2-(2-aminoethylphenyl)]-Pd-(II)}/ [RuPhos] admixture (PdP/P = 1:1) zugegeben und 1,5 Stunden auf 100°C erhitzt. Der Endcapper **(15)** wird dabei als löslichkeitsvermittelnde Gruppe eingesetzt.

Das Katalysator-System ist in der folgenden Abbildung dargestellt.

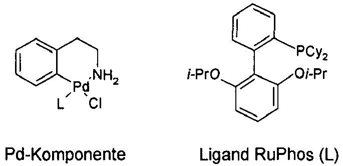

Die Molekulargewichte Mₙ und M_{w} sowie die Polydispersität PD des Polymeren HBP10 sind in der Tabelle 3 aufgelistet.

### Beispiel 9

### Polymerisation des Monomeren (11) mit den Endgruppen (16) und (17)

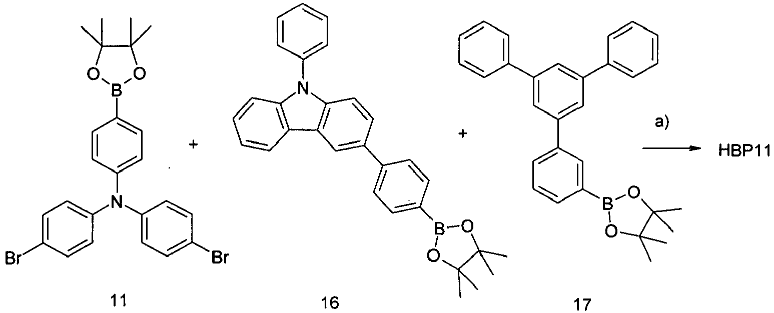

2,12 g (4,00 mmol) Monomer **(11)** und 4,20 mmol von zwei unterschiedlichen Endcappern **(16)** und **(17)** werden mit einem Toluol/Dioxan/Wasser-Gemisch (jeweils 40 ml) mit 17,6 mmol K₃PO₄ als Base für 30 Minuten entgast. Es werden dann 55,8 mg (80 µmol) RuPhos zugegeben und 1,5 Stunden auf 100°C erhitzt.

Die Endgruppe **(16)** trägt eine zusätzliche Carbazol-Funktion [hergestellt durch Borylierung von 3-(4-Bromphenyl)-9-phenyl-9H-carbazol], was in lochleitenden Schichten desöfteren mit Triarylaminen kombiniert eingesetzt wird. Als zweite Endgruppe wird **(17)** als Löslichkeitsvermittler gewählt.

Die Polymerisationen zu **HBP 11a** und **HBP 11b** geschehen unter den gleichen Bedingungen wie für **HBP 10** beschrieben, die Mengen an **(16)** und **(17)** variieren hierbei leicht. Für **HBP 11a** werden 0,85 Äquivalente **(16)** und 0,20 Äquivalente **(17)** eingesetzt, für **HBP 11b** sind dies 0,80 Äquivalente **(16)** und 0,25 Äquivalente **(17).**

Die Molekulargewichte Mₙ und M_{w} sowie die Polydispersität PD der Polymeren HBP11a und HBP11b sind in der Tabelle 3 aufgelistet.

### Beispiel 10

### Polymerisation des Monomeren (11) mit den Endgruppen (16), (17) und (18)

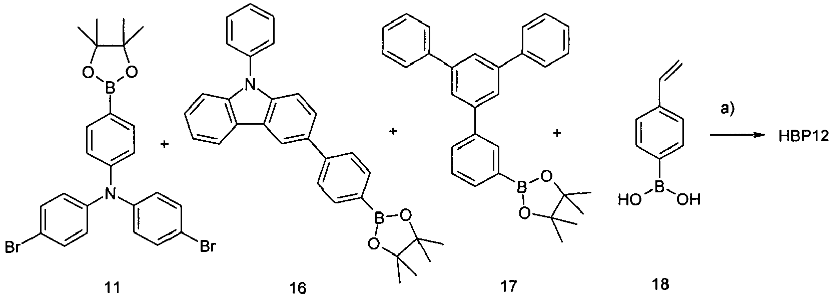

2,12 g (4,00 mmol) Monomer **(11)** und 4,20 mmol von drei unterschiedlichen Endcappern **(16), (17)** und **(18)** werden mit einem Toluol/Dioxan/Wasser-Gemisch (jeweils 40 ml) mit 17,6 mmol K₃PO₄ als Base für 30 Minuten entgast. Es werden dann 55,8 mg (80 µmol) RuPhos zugegeben und 1,5 Stunden auf 100°C erhitzt.

Das Monomer **(11)** wird somit in einem Schritt außer mit den beiden unterschiedlichen Endgruppen (16) und (17) (siehe Beispiel 9) zusätzlich mit einer weiteren Endgruppe **(18)** funktionalisiert Die zusätzliche Endgruppe, die 4-Styryl-boronsäure **(18),** fungiert im hyperverzweigten Polymer als vernetzbare Gruppe und soll das lochleitende Polymer im Film der OLED unlöslich machen.

Die Polymerisation zu **HBP12** geschieht unter den gleichen Bedingungen wie für **HBP 10** beschrieben. Für **HBP12** werden 0,70 Äquivalente **(16)** und 0,25 Äquivalente **(17)** und 0,10 Äquivalente **(18)** eingesetzt Die Molekulargewichte Mₙ und M_{w} sowie die Polydispersität PD des Polymeren HBP12 sind in der Tabelle 3 aufgelistet.

**Tabelle 3: Molekulargewichte, Polydispersitäten und Bromgehalt von HBP 10, HBP 11a, HBP 11b, HBP 12**

| | **Mn** | **M_{w}** | **PD** |
|---|---|---|---|
| **HBP 10** | 23900 | 57500 | 2.4 |
| **HBP 11a** | 18800 | 84600 | 4.5 |
| **HBP 11b** | 22500 | 56400 | 2.5 |
| **HBP 12** | 16000 | 26300 | 1.6 |

### Beispiele 11 und 12

### Herstellung von OLED-Devices

### Device-Daten der Lochtransportmaterialien

Die in den Beispiel 7 hergestellten hyperverzweigten Polymere **HBP 7** und **HBP 8** werden als Lochtransportmaterialien in einer blau emittierenden OLED eingesetzt.

Dazu werden auf einer ITO-Anode 20 nm PEDOT:PSS aus wässriger Lösung und danach 20 nm des hergestellten hyperverzweigten Polymers als Lochtransportmaterial (HTM) aus toluolischer Lösung aufgebracht. Auf dieser Lochtransportschicht wird die emittierende Schicht (EML) (20 nm) aufgebracht. Dazu werden das Matrixmaterial M1 (99%) sowie der dunkelblaue Emitter E1 (1%) aufgedampft.

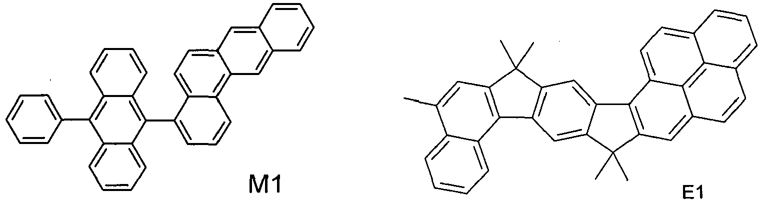

Auf dieser Emitterschicht wird die Elektronentransportschicht (ETL) (30 nm) aufgedampft, die die beiden folgenden Materialien zu jeweils 50% enthält.

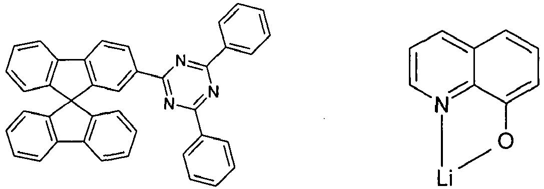

Abschließend wird eine 100 nm dicke Aluminiumschicht als Kathode aufgebracht.

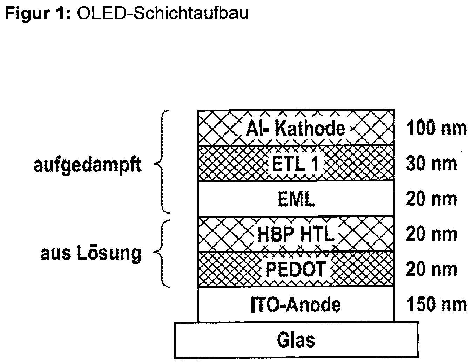

Der Device-Aufbau ist in Figur 1 dargestellt. In Tabelle 4 werden die elektrooptischen Daten der beiden OLED-Bauteile miteinander verglichen.

### Elektrooptische Charakterisierung:

Für die elektrooptische Charakterisierung werden die in den Beispielen 11 und 12 hergestellten OLEDs in für die Substratgröße eigens angefertigte Halter eingespannt und mittels Federkontakten kontaktiert. Eine Photodiode mit Augenverlaufsfilter kann direkt auf den Messhalter aufgesetzt werden, um Einflüsse von Fremdlicht auszuschließen.

Typischerweise werden die Spannungen von 0 bis max. 20 V in 0,2 V-Schritten erhöht und wieder erniedrigt. Für jeden Messpunkt wird der Strom durch die PLED sowie der erhaltene Photostrom von der Photodiode gemessen. Auf diese Art und Weise erhält man die IVL-Daten der Test-PLED. Wichtige Kenngrößen sind die gemessene maximale Effizienz ("Eff." in cd/A), die externe Quanteneffizienz (EQE in %) und die Spannung (U in Volt).

Um außerdem die Farbe und das genaue Elektrolumineszenzspektrum der Test-PLED zu kennen, wird nach der ersten Messung nochmals die benötigte Spannung angelegt und die Photodiode durch einen Spektrum-Messkopf ersetzt. Dieser ist durch eine Lichtleitfaser mit einem Spektrometer (Ocean Optics) verbunden. Aus dem gemessenen Spektrum können die Farbkoordinaten (CIE: Commission International de l'éclairage, Normalbetrachter von 1931) abgeleitet werden.

**Tabelle 4: Elektrooptische Daten der aus Lösung prozessierten OLEDs im Device-Aufbau B mit HBP 7 und HBP 8; ^{a)} @1000 cd/m²; ^{b)} @10 mA/cm².**

| HBP | EL [nm] | CIE x/y | Effizienz^{a)} [cd/A] | EQE^{a)} [%] | Spannung^{b)} [V] |
|---|---|---|---|---|---|
| **HBP 7** | 446,476 | 0.15/0.12 | 4.3 | 3.9 | 3.8 |
| **HBP 8** | 446,476 | 0.15/0.13 | 3.7 | 3.5 | 3.6 |

Die CIE-Farbkoordinaten weichen nur geringfügig voneinander ab, im EL-Spektrum liegen beide Kurven fast übereinander. Die EL-Maxima betragen λₘₐₓ = 446 nm und λ = 476 nm mit einer Schulter im bathochromen Bereich.

Die Effizienz der OLED mit **HBP 7** ist mit 4.3 cd/A etwas höher als die im Bauteil mit **HBP 8** (3.7 cd/A), es liegen aber beide Effizienzen im zu erwartenden Bereich. Die Stromdichte-Spannungs-Kennlinien verlaufen sehr ähnlich.

## Patentansprüche

1. Hyperverzweigtes Polymer enthaltend mindestens eine Einheit der allgemeinen Formel (I) 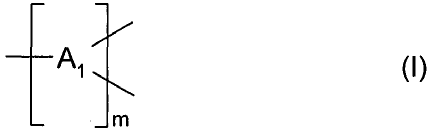 wobei
A₁ ein funktionales Strukturelement ist,
m eine ganze Zahl ≥ 3 ist und
die Linien Verbindungen zu weiteren Einheiten des Polymeren darstellen und
mindestens eine Einheit der allgemeinen Formel (II)
-[-A₂]_{I} (II)
wobei
A₂ ein von A₁ verschiedenes, funktionales Strukturelement ist,
I eine ganze Zahl ≥ 1 ist und
die Linie die Verbindung zu einer anderen Einheit des Polymeren darstellt, **dadurch gekennzeichnet,**
**dass** das funktionale Strukturelement A₁ oder A₂ ein Strukturelement ist, das Lochinjektions- und/oder Lochtransporteigenschaften aufweist und ausgewählt ist aus Triarylamin-, Benzidin-, Tetraaryl-paraphenylendiamin-, Triarylphosphin-, Phenothiazin-, Phenoxazin-, Dihydrophenazin-, Thianthren-, Dibenzo-para-dioxin-, Phenoxathiin-, Carbazol-, Azulen-, Thiophen-, Pyrrol- und Furanderivaten und weiteren O-, S- oder N-haltigen Heterocyclen mit hoch liegendem HOMO (HOMO = höchstes besetztes Molekülorbital), oder
**dass** das funktionale Strukturelement A₁ oder A₂ ein Strukturelement ist, das Elektroneninjektions- und/oder Elektronentransporteigenschaften auf-weist und ausgewählt ist aus Pyridin-, Pyrimidin-, Pyridazin-, Pyrazin-, Oxadiazol-, Chinolin-, Chinoxalin-, Anthracen-, Benzanthracen-, Pyren-, Perylen-, Benzimidazol-, Triazin-, Triphenylen-, Keton-, Phosphinoxid- und Phenazinderivaten, aber auch Triarylboranen und weiteren O-, S- oder N-haltigen Heterocyclen mit niedrig liegendem LUMO (LUMO = niedrigstes unbesetztes Molekülorbital),
**dass** das funktionale Strukturelement A₁ oder A₂ ein Strukturelement ist, das Licht emittiert und ausgewählt ist aus fluoreszierenden und phosphoreszierenden Emittern, oder.
**dass** das funktionale Strukturelement A₁ oder A₂ ein Strukturelement ist, das ein Hostmaterial ist und ausgewählt ist aus Oligoarylenen.und dass mindestens eine Einheit der allgemeinen Formel (I) oder mindestens eine Einheit der allgemeinen Formel (II) ausgewählt ist aus einer löslichkeitsvermittelnden Einheit der allgemeinen Formel (III): 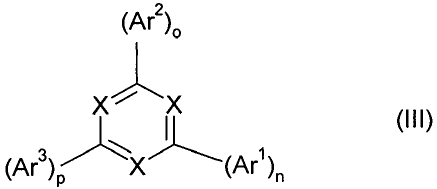 wobei
Ar¹, Ar², Ar³ jeweils unabhängig voneinander eine Aryl- oder Heteroarylgruppe ist, welche mit einem oder mehreren beliebigen Resten R¹ substituiert sein kann,
X jeweils unabhängig voneinander N oder CR², vorzugsweise CH ist,
R¹, R² jeweils unabhängig voneinander Wasserstoff, eine gerad-kettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen ist oder eine Silylgruppe oder eine substituierte Ketogruppe mit 1 bis 40 C-Atomen, eine Alkoxycarbonylgruppe mit 2 bis 40 C-Atomen, eine Aryloxycarbonylgruppe mit 7 bis 40 C-Atomen, eine Cyanogruppe (-CN), eine Carbamoylgruppe (-C(=O)NH₂), eine Haloformylgruppe (-C(=O)-X, worin X ein Halogenatom darstellt), eine Formylgruppe (-C(=O)-H), eine Isocyanogruppe, eine Isocyanatgruppe, eine Thiocyanat-gruppe oder eine Thioisocyanatgruppe, eine Hydroxygruppe, eine Nitrogruppe, eine CF₃-Gruppe, Cl, Br, F, eine vernetzbare Gruppe oder ein substituiertes oder unsubstituiertes aromatisches oder heteroaromatisches Ring-system mit 5 bis 60 Ringatomen, oder eine Aryloxy- oder Heteroaryloxygruppe mit 5 bis 60 Ringatomen, oder eine Kombination dieser Systeme ist, wobei eine oder mehrere der Gruppen R¹ und/oder R² ein mono- oder polycyclisches, aliphatisches oder aromatisches Ringsystem miteinander und/oder mit dem Ring, an dem die Gruppe R¹ gebunden ist, bilden können; und
n, o, p jeweils unabhängig voneinander, gleich oder verschieden 0 oder 1 sein können
wobei gilt, dass die löslichkeitsvermittelnde Einheit der allgemeinen Formel (III) drei Bindungen zu anderen Einheiten des Polymeren aufweist, falls sie eine Einheit der allgemeinen Formel (I) darstellt, und dass die löslichkeitsvermittelnde Einheit der allgemeinen Formel (III) eine Bindung zu einer anderen Einheit des Polymeren aufweist, falls sie eine Einheit der allgemeinen Formel (II) darstellt.

2. Polymer nach Anspruch 1, **dadurch gekennzeichnet, dass** das funktionale Strukturelement A₁ oder A₂ eine löslichkeitsvermittelnde Einheit der allgemeinen Formel (III) ist: 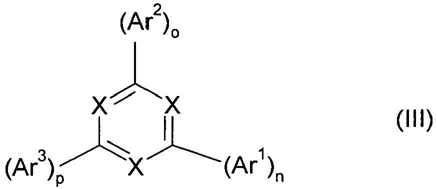 wobei
Ar¹, Ar², Ar³ jeweils unabhängig voneinander eine Aryl- oder Heteroarylgruppe ist, welche mit einem oder mehreren beliebigen Resten R¹ substituiert sein kann,
X jeweils unabhängig voneinander N oder CR², vorzugsweise CH ist,
R¹, R² jeweils unabhängig voneinander Wasserstoff, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen ist oder eine Silylgruppe oder eine substituierte Ketogruppe mit 1 bis 40 C-Atomen, eine Alkoxy-carbonylgruppe mit 2 bis 40 C-Atomen, eine Aryloxycarbonyl-gruppe mit 7 bis 40 C-Atomen, eine Cyanogruppe (-CN), eine Carbamoylgruppe (-C(=O)NH₂), eine Haloformylgruppe (-C(=O)-X, worin X ein Halogenatom darstellt), eine Formylgruppe (-C(=O)-H), eine Isocyanogruppe, eine Isocyanatgruppe, eine Thiocyanat-gruppe oder eine Thioisocyanatgruppe, eine Hydroxygruppe, eine Nitrogruppe, eine CF₃-Gruppe, Cl, Br, F, eine vernetzbare Gruppe oder ein substituiertes oder unsubstituiertes aromatisches oder heteroaromatisches Ringsystem mit 5 bis 60 Ringatomen, oder eine Aryloxy- oder Heteroaryloxygruppe mit 5 bis 60 Ringatomen, oder eine Kombination dieser Systeme ist, wobei eine oder mehrere der Gruppen R¹ und/oder R² ein mono- oder polycyclisches, aliphatisches oder aromatisches Ringsystem miteinander und/oder mit dem Ring, an dem die Gruppe R¹ gebunden ist, bilden können, und
n, o, p jeweils unabhängig voneinander, gleich oder verschieden 0 oder 1 sein können,
wobei gilt, dass die löslichkeitsvermittelnde Einheit der allgemeinen Formel (III) drei Bindungen zu anderen Einheiten des Polymeren aufweist, falls sie eine Einheit der allgemeinen Formel (I) darstellt, und dass die löslichkeitsvermittelnde Einheit der allgemeinen Formel (III) eine Bindung zu einer anderen Einheit des Polymeren aufweist, falls sie eine Einheit der allgemeinen Formel (II) darstellt.

3. Polymer nach Anspruch 1 und 2, **dadurch gekennzeichnet, dass** die Einheiten der allgemeinen Formel (I) ausgewählt sind aus:
- Einheiten gemäß Anspruch 1, die Lochinjektions- und/oder Lochtransporteigenschaften aufweisen,
- Einheiten gemäß Anspruch 1, die Elektroneninjektions- und/oder Elektronentransporteigenschaften aufweisen, und
- Einheiten gemäß Anspruch 1, welche lichtemittierende Eigenschaften aufweisen und
die Einheiten der allgemeinen Formel (II) ausgewählt sind aus löslichkeitsvermittelnden Struktureinheiten der allgemeinen Formel (III) nach Anspruch 2.

4. Polymer nach Anspruch 1 und 2, **dadurch gekennzeichnet, dass** die Einheiten der allgemeinen Formel (I) ausgewählt sind aus löslichkeitsvermittelnden Struktureinheiten der allgemeinen Formel (III) nach Anspruch 2 und
die Einheiten der allgemeinen Formel (II) ausgewählt sind aus:
- Einheiten gemäß Anspruch 1, die Lochinjektions- und/oder Lochtransporteigenschaften aufweisen,
- Einheiten gemäß Anspruch 1, die Elektroneninjektions- und/oder Elektronentransporteigenschaften aufweisen, und
- Einheiten gemäß Anspruch 1, welche lichtemittierende Eigenschaften aufweisen.

5. Polymermischung enthaltend ein oder mehrere hyperverzweigte Polymere nach einem oder mehreren der vorhergehenden Ansprüche sowie eine oder mehrere weitere polymere, oligomere, dendritische oder niedermolekulare Substanzen.

6. Formulierung enthaltend ein oder mehrere hyperverzweigte Polymere nach einem oder mehreren der Ansprüche 1 bis 4 oder eine Polymermischung nach Anspruch 5 in einem oder mehreren Lösungsmitteln.

7. Verwendung der hyperverzweigten Polymere nach einem oder mehreren der Ansprüche 1 bis 4, der Polymermischung nach Anspruch 5 und der Formulierung nach Anspruch 6 in elektronischen oder elektrooptischen Vorrichtungen.

8. Elektronische oder optoelektronische Vorrichtungen, vorzugsweise organische bzw. polymere organische Elektrolumineszenzvorrichtungen (OLED, PLED), organische Feld-Effekt-Transistoren (OFETs), organische integrierte Schaltungen (O-ICs), organische Dünnfilmtransistoren (TFTs), organische Solarzellen (O-SCs), organische Laserdioden (O-Laser), organische photovoltaische (OPV) Elemente oder Vorrichtungen oder organische Photorezeptoren (OPCs), besonders bevorzugt organische bzw. polymere organische Elektrolumineszenzvorrichtungen, insbesondere polymere organische Elektrolumineszenzvorrichtungen, mit einer oder mehreren aktiven Schichten, wobei mindestens eine dieser aktiven Schichten ein oder mehrere hyperverzweigte Polymere nach einem oder mehreren der Ansprüche 1 bis 4 enthält.

## Claims

1. Hyperbranched polymer containing at least one unit of the general formula (I) 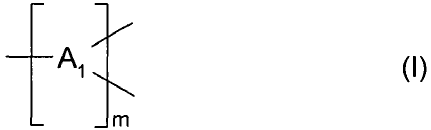 where
A₁ is a functional structural element,
m is an integer ≥ 3 and
the lines represent connections to further units of the polymer and
at least one unit of the general formula (II)
-[-A₂]_{I} (II)
where
A₂ is a functional structural element which is different from A₁,
I is an integer ≥ 1 and
the line represents the connection to another unit of the polymer, **characterised in that** the functional structural element A₁ or A₂ is a structural element which has hole-injection and/or hole-transport properties and is selected from triarylamine, benzidine, tetraaryl-para-phenylenediamine, triarylphosphine, phenothiazine, phenoxazine, dihydrophenazine, thianthrene, dibenzo-para-dioxin, phenoxathiyne, carbazole, azulene, thiophene, pyrrole and furan derivatives and further O-, S- or N-containing heterocycles having a high HOMO (HOMO = highest occupied molecular orbital), or
**in that** the functional structural element A₁ or A₂ is a structural element which has electron-injection and/or electron-transport properties and is selected from pyridine, pyrimidine, pyridazine, pyrazine, oxadiazole, quinoline, quinoxaline, anthracene, benzanthracene, pyrene, perylene, benzimidazole, triazine, triphenylene, ketone, phosphine oxide and phenazine derivatives, but also triarylboranes and further O-, S-or N-containing heterocycles having a low LUMO (LUMO = lowest unoccupied molecular orbital),
**in that** the functional structural element A₁ or A₂ is a structural element which emits light and is selected from fluorescent and phosphorescent emitters, or
**in that** the functional structural element A₁ or A₂ is a structural element which is a host material and is selected from oligoarylenes, and
**in that** at least one unit of the general formula (I) or at least one unit of the general formula (II) is selected from a solubility-promoting unit of the general formula (III): 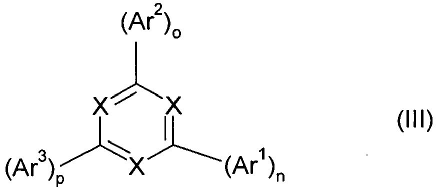 where
Ar¹, Ar², Ar³ are each, independently of one another, an aryl or heteroaryl group, which may be substituted by one or more of any desired radicals R¹,
X is in each case, independently of one another, N or CR², preferably CH,
R¹, R² are each, independently of one another, hydrogen, a straightchain alkyl, alkoxy or thioalkoxy group having 1 to 40 C atoms or a branched or cyclic alkyl, alkoxy or thioalkoxy group having 3 to 40 C atoms or are a silyl group or a substituted keto group having 1 to 40 C atoms, an alkoxycarbonyl group having 2 to 40 C atoms, an aryloxycarbonyl group having 7 to 40 C atoms, a cyano group (-CN), a carbamoyl group (-C(=O)NH₂), a haloformyl group (-C(=O)-X, in which X represents a halogen atom), a formyl group (-C(=O)-H), an isocyano group, an isocyanate group, a thiocyanate group or a thioisocyanate group, a hydroxyl group, a nitro group, a CF₃ group, Cl, Br, F, a crosslinkable group or a substituted or unsubstituted aromatic or heteroaromatic ring system having 5 to 60 ring atoms, or an aryloxy or heteroaryloxy group having 5 to 60 ring atoms, or a combination of these systems, where one or more of the groups R¹ and/or R² may form a mono- or polycyclic, aliphatic or aromatic ring system with one another and/or with the ring to which the group R¹ is bonded; and
n, o, p may each, independently of one another, identically or differently, be 0 or 1
where the solubility-promoting unit of the general formula (III) has three bonds to other units of the polymer if it represents a unit of the general formula (I), and the solubility-promoting unit of the general formula (III) has one bond to another unit of the polymer if it represents a unit of the general formula (II).

2. Polymer according to Claim 1, **characterised in that** the functional structural element A₁ or A₂ is a solubility-promoting unit of the general formula (III): 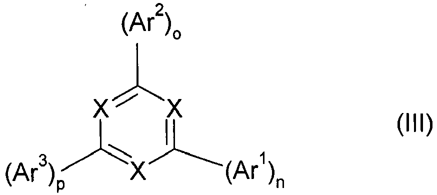 where
Ar¹, Ar², Ar³ are each, independently of one another, an aryl or heteroaryl group, which may be substituted by one or more of any desired radicals R¹,
X is in each case, independently of one another, N or CR², preferably CH,
R¹, R² are each, independently of one another, hydrogen, a straightchain alkyl, alkoxy or thioalkoxy group having 1 to 40 C atoms or a branched or cyclic alkyl, alkoxy or thioalkoxy group having 3 to 40 C atoms or are a silyl group or a substituted keto group having 1 to 40 C atoms, an alkoxycarbonyl group having 2 to 40 C atoms, an aryloxycarbonyl group having 7 to 40 C atoms, a cyano group (-CN), a carbamoyl group (-C(=O)NH₂), a haloformyl group (-C(=O)-X, in which X represents a halogen atom), a formyl group (-C(=O)-H), an isocyano group, an isocyanate group, a thiocyanate group or a thioisocyanate group, a hydroxyl group, a nitro group, a CF₃ group, Cl, Br, F, a crosslinkable group or a substituted or unsubstituted aromatic or heteroaromatic ring system having 5 to 60 ring atoms, or an aryloxy or heteroaryloxy group having 5 to 60 ring atoms, or a combination of these systems, where one or more of the groups R¹ and/or R² may form a mono- or polycyclic, aliphatic or aromatic ring system with one another and/or with the ring to which the group R¹ is bonded, and
n, o, p may each, independently of one another, identically or differently, be 0 or 1,
where the solubility-promoting unit of the general formula (III) has three bonds to other units of the polymer if it represents a unit of the general formula (I), and the solubility-promoting unit of the general formula (III) has one bond to another unit of the polymer if it represents a unit of the general formula (II).

3. Polymer according to Claim 1 or 2, **characterised in that** the units of the general formula (I) are selected from:
- units according to Claim 1 which have hole-injection and/or hole-transport properties,
- units according to Claim 1 which have electron-injection and/or electron-transport properties, and
- units according to Claim 1 which have light-emitting properties and the units of the general formula (II) are selected from solubility-promoting structural units of the general formula (III) according to Claim 2.

4. Polymer according to Claim 1 or 2, **characterised in that** the units of the general formula (I) are selected from solubility-promoting structural units of the general formula (III) according to Claim 2 and
the units of the general formula (II) are selected from:
- units according to Claim 1 which have hole-injection and/or hole-transport properties,
- units according to Claim 1 which have electron-injection and/or electron-transport properties, and
- units according to Claim 1 which have light-emitting properties.

5. Polymer mixture comprising one or more hyperbranched polymers according to one or more of the preceding claims and one or more further polymeric, oligomeric, dendritic or low-molecular-weight substances.

6. Formulation comprising one or more hyperbranched polymers according to one or more of Claims 1 to 4 or a polymer mixture according to Claim 5 in one or more solvents.

7. Use of the hyperbranched polymers according to one or more of Claims 1 to 4, the polymer mixture according to Claim 5 and the formulation according to Claim 6 in electronic or electro-optical devices.

8. Electronic or opto-electronic devices, preferably organic or polymeric organic electroluminescent devices (OLEDs, PLEDs), organic field-effect transistors (OFETs), organic integrated circuits (O-ICs), organic thin-film transistors (TFTs), organic solar cells (O-SCs), organic laser diodes (O-lasers), organic photovoltaic (OPV) elements or devices or organic photoreceptors (OPCs), particularly preferably organic or polymeric organic electroluminescent devices, in particular polymeric organic electroluminescent devices, having one or more active layers, where at least one of these active layers comprises one or more hyperbranched polymers according to one or more of Claims 1 to 4.

## Revendications

1. Polymère hyper-ramifié contenant au moins une unité de la formule générale (I) : 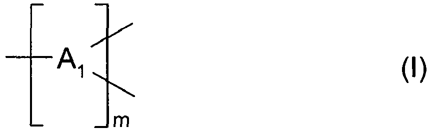 dans laquelle :
A₁ est un élément structurel fonctionnel,
m est un entier ≥ 3 et
les lignes représentent des connexions sur d'autres unités du polymère et
au moins une unité de la formule générale (II) :
-[-A₂]_{I} (II)
dans laquelle :
A₂ est un élément structurel fonctionnel qui est différent de A₁,
I est un entier ≥ 1 et
la ligne représente la connexion sur une autre unité du polymère, **caractérisé en ce que** l'élément structurel fonctionnel A₁ ou A₂ est un élément structurel qui présente des propriétés d'injection de trous et/ou de transport de trous et est choisi parmi les dérivés de triarylamine, de benzidine, de tétraaryl-para-phénylènediamine, de triarylphosphine, de phénothiazine, de phénoxazine, de dihydrophénazine, de thianthrène, de dibenzo-para-dioxine, de phénoxathiyne, de carbazole, d'azulène, de thiophène, de pyrrole et de furane et en outre les hétérocycles contenant O, S ou N présentant une HOMO (HOMO = orbite moléculaire occupée la plus haute) haute, ou
**en ce que** l'élément structurel fonctionnel A₁ ou A₂ est un élément structurel qui présente des propriétés d'injection d'électrons et/ou de transport d'électrons et est choisi parmi les dérivés de pyridine, de pyrimidine, de pyridazine, de pyrazine, d'oxadiazole, de quinoline, de quinoxaline, d'anthracène, de benzanthracène, de pyrène, de pérylène, de benzimidazole, de triazine, de triphénylène, de cétone, d'oxyde de phosphine et de phénazine, mais également les triarylboranes et en outres les hétérocycles contenant O, S ou N présentant une LUMO (LUMO = orbite moléculaire non occupée la plus basse) basse,
**en ce que** l'élément structurel fonctionnel A₁ ou A₂ est un élément structurel qui émet de la lumière et qui est choisi parmi les émetteurs fluorescents et phosphorescents, ou
**en ce que** l'élément structurel fonctionnel A₁ ou A₂ est un élément structurel qui est un matériau hôte et qui est choisi parmi les oligoarylènes, et
**en ce qu'**au moins une unité de la formule générale (I) ou au moins une unité de la formule générale (II) est choisie parmi une unité favorisant la solubilité de la formule générale (III) : 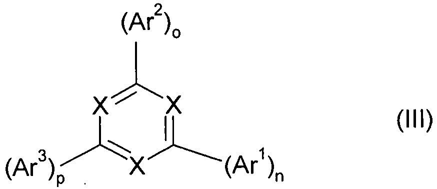 dans laquelle :
Ar¹, Ar², Ar³ sont chacun, indépendamment les uns des autres, un groupe aryle ou hétéroaryle, lequel peut être substitué par n'importe quel(s) radical ou plusieurs radicaux souhaité(s) R¹,
X est dans chaque cas, indépendamment des autres, N ou CR², de façon préférable CH,
R¹, R² sont chacun, indépendamment l'un de l'autre, hydrogène, un groupe alkyle, alcoxy ou thioalcoxy en chaîne droite comportant 1 à 40 atome(s) de C ou un groupe alkyle, alcoxy ou thioalcoxy ramifié ou cyclique comportant 3 à 40 atomes de C ou un groupe silyle ou un groupe céto substitué comportant 1 à 40 atome(s) de C, un groupe alcoxycarbonyle comportant 2 à 40 atomes de C, un groupe aryloxycarbonyle comportant 7 à 40 atomes de C, un groupe cyano (-CN), un groupe carbamoyle (-C(=O)NH₂), un groupe haloformyle (-C(=O)-X, dans lequel X représente un atome d'halogène), un groupe formyle (-C(=O)-H), un groupe isocyano, un groupe isocyanate, un groupe thiocyanate ou un groupe thioisocyanate, un groupe hydroxyle, un groupe nitro, un groupe CF₃, CI, Br, F, un groupe réticulable ou un système de cycle aromatique ou hétéroaromatique substitué ou non substitué comportant 5 à 60 atomes de cycle, ou un groupe aryloxy ou hétéroaryloxy comportant 5 à 60 atomes de cycle, ou une combinaison de ces systèmes, où un ou plusieurs des groupes R¹ et/ou R² peut/peuvent former un système de cycle aliphatique ou aromatique monocyclique ou polycyclique les uns avec les autres et/ou avec le cycle auquel le groupe R¹ est lié ; et
n, o, p peuvent chacun, indépendamment les uns des autres, de manière identique ou différente, être 0 ou 1,
où l'unité favorisant la solubilité de la formule générale (III) comporte trois liens sur d'autres unités du polymère si elle représente une unité de la formule générale (I), et l'unité favorisant la solubilité de la formule générale (III) comporte un seul lien sur une autre unité du polymère si elle représente une unité de la formule générale (II).

2. Polymère selon la revendication 1, **caractérisé en ce que** l'élément structurel fonctionnel A₁ ou A₂ est une unité favorisant la solubilité de la formule générale (III) : 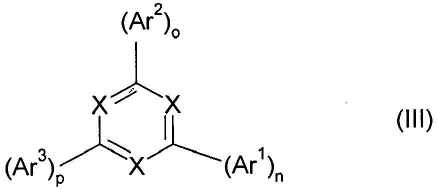 dans laquelle :
Ar¹, Ar², Ar³ sont chacun, indépendamment les uns des autres, un groupe aryle ou hétéroaryle, lequel peut être substitué par n'importe quel(s) radical ou plusieurs radicaux souhaité(s) R¹,
X est dans chaque cas, indépendamment des autres, N ou CR², de façon préférable CH,
R¹, R² sont chacun, indépendamment l'un de l'autre, hydrogène, un groupe alkyle, alcoxy ou thioalcoxy en chaîne droite comportant 1 à 40 atome(s) de C ou un groupe alkyle, alcoxy ou thioalcoxy ramifié ou cyclique comportant 3 à 40 atomes de C ou sont un groupe silyle ou un groupe céto substitué comportant 1 à 40 atome(s) de C, un groupe alcoxycarbonyle comportant 2 à 40 atomes de C, un groupe aryloxycarbonyle comportant 7 à 40 atomes de C, un groupe cyano (-CN), un groupe carbamoyle (-C(=O)NH₂), un groupe haloformyle (-C(=O)-X, dans lequel X représente un atome d'halogène), un groupe formyle (-C(=O)-H), un groupe isocyano, un groupe isocyanate, un groupe thiocyanate ou un groupe thioisocyanate, un groupe hydroxyle, un groupe nitro, un groupe CF₃, CI, Br, F, un groupe réticulable ou un système de cycle aromatique ou hétéroaromatique substitué ou non substitué comportant 5 à 60 atomes de cycle, ou un groupe aryloxy ou hétéroaryloxy comportant 5 à 60 atomes de cycle, ou une combinaison de ces systèmes, où un ou plusieurs des groupes R¹ et/ou R² peut/peuvent former un système de cycle aliphatique ou aromatique monocyclique ou polycyclique les uns avec les autres et/ou avec le cycle auquel le groupe R¹ est lié, et
n, o, p peuvent chacun, indépendamment les uns des autres, de manière identique ou différente, être 0 ou 1,
où l'unité favorisant la solubilité de la formule générale (III) comporte trois liens sur d'autres unités du polymère si elle représente une unité de la formule générale (I), et l'unité favorisant la solubilité de la formule générale (III) comporte un seul lien sur une autre unité du polymère si elle représente une unité de la formule générale (II).

3. Polymère selon la revendication 1 ou 2, **caractérisé en ce que** les unités de la formule générale (I) sont choisies parmi :
- des unités selon la revendication 1 qui présentent des propriétés d'injection de trous et/ou de transport de trous,
- des unités selon la revendication 1 qui présentent des propriétés d'injection d'électrons et/ou de transport d'électrons, et
- des unités selon la revendication 1 qui présentent des propriétés d'émission de lumière, et
les unités de la formule générale (II) sont choisies parmi des unités structurelles favorisant la solubilité de la formule générale (III) selon la revendication 2.

4. Polymère selon la revendication 1 ou 2, **caractérisé en ce que** les unités de la formule générale (I) sont choisies parmi des unités structurelles favorisant la solubilité de la formule générale (III) selon la revendication 2 et
les unités de la formule générale (II) sont choisies parmi :
- des unités selon la revendication 1 qui présentent des propriétés d'injection de trous et/ou de transport de trous,
- des unités selon la revendication 1 qui présentent des propriétés d'injection d'électrons et/ou de transport d'électrons, et
- des unités selon la revendication 1 qui présentent des propriétés d'émission de lumière.

5. Mélange de polymères comprenant un ou plusieurs polymère(s) hyper-ramifié(s) selon une ou plusieurs des revendications précédentes et une ou plusieurs autre(s) substance(s) polymérique(s), oligomérique(s), dendritique(s) ou de poids moléculaire faible.

6. Formulation comprenant comprenant un ou plusieurs polymère(s) hyper-ramifié(s) selon une ou plusieurs des revendications 1 à 4 ou un mélange de polymères selon la revendication 5 dans un ou plusieurs solvants.

7. Utilisation des polymères hyper-ramifiés selon une ou plusieurs des revendications 1 à 4, du mélange de polymères selon la revendication 5 et de la formulation selon la revendication 6 dans des dispositifs électroniques ou électro-optiques.

8. Dispositifs électroniques ou opto-électroniques, de façon préférable des dispositifs électroluminescents organiques ou organiques polymériques (OLED, PLED), des transistors à effet de champ organiques (OFET), des circuits intégrés organiques (O-IC), des transistors à film mince organiques (TFT), des cellules solaires organiques (O-SC), des diodes laser organiques (O-laser), des éléments ou dispositifs photovoltaïques organiques (OPV) ou des photorécepteurs organiques (OPC), de façon particulièrement préférable des dispositifs électroluminescents organiques ou organiques polymériques, en particulier des dispositifs électroluminescents organique polymériques, comportant une ou plusieurs couche(s) active(s), où au moins l'une de ces couches actives comprend un ou plusieurs polymère(s) hyper-ramifié(s) selon une ou plusieurs des revendications 1 à 4.
